# EUROPEAN PATENT SPECIFICATION

(11) **EP 2 924 769 B1**
(45) Date of publication and mention of the grant of the patent: **18.04.2018**
(21) Application number: 13856469.5
(22) Date of filing: 19.11.2013
(51) Int. Cl.: C22C 18/04, C22C 24/00, C22C 30/00, C22C 30/04, C22C 30/06, H01M 4/134, H01M 4/1395, H01M 4/38, H01M 4/62, C22C 18/00, C23C 14/34, C23C 14/16, H01M 10/0585, H01M 10/0525

(54) **NEGATIVE ELECTRODE FOR ELECTRICAL DEVICE AND ELECTRICAL DEVICE PROVIDED WITH SAME**
NEGATIVELEKTRODE FÜR EINE ELEKTRISCHE VORRICHTUNG UND ELEKTRISCHE VORRICHTUNG DAMIT
ÉLECTRODE NÉGATIVE POUR UN DISPOSITIF ÉLECTRIQUE ET DISPOSITIF ÉLECTRIQUE POURVU DE CETTE DERNIÈRE

(30) Priority: 22.11.2012 JP 2012256920
(43) Date of publication of application: 30.09.2015
(73) Proprietor: NISSAN MOTOR CO., LTD., Yokohama-shi, Kanagawa 220-8623 (JP)
(72) Inventor: YAMAMOTO, Kensuke, Atsugi-shi Kanagawa 243-0123 (JP); WATANABE, Manabu, Atsugi-shi Kanagawa 243-0123 (JP); MIKI, Fumihiro, Atsugi-shi Kanagawa 243-0123 (JP); SANADA, Takashi, Atsugi-shi Kanagawa 243-0123 (JP); CHIBA, Nobutaka, Atsugi-shi Kanagawa 243-0123 (JP)
(74) Representative: Hoefer & Partner Patentanwälte mbB
(86) International application number: PCT/JP2013/081148
(87) International publication number: WO 2014/080897

(56) References cited:
- WO-A1-2004/086539
- WO-A1-2011/065504
- WO-A1-2012/121240
- WO-A1-2012/160854
- WO-A1-2013/088846
- WO-A1-2013/088846
- JP-A- H08 250 117
- JP-A- 2004 311 429
- JP-A- 2010 135 336
- JP-A- 2011 192 453
- US-A1- 2010 119 942

## Description

### TECHNICAL FIELD

The invention relates to a negative electrode for an electric device, and an electric device using same. The negative electrode for an electric device and the electric device using same according to the present invention are used as, for example, a secondary battery, a capacitor and the like for a power supply or an auxiliary power supply for driving a motor and the like of a vehicle such as an electric vehicle, a fuel-cell vehicle, and a hybrid electric vehicle.

### BACKGROUND ART

In recent years, reduction of an amount of carbon dioxide has been earnestly desired in order to deal with air pollution and global warming. In the automobile industry, expectation is centered on reduction in carbon dioxide emission by introducing electric vehicles (EV) and hybrid electric vehicles (HEV), and electric devices, which hold the key to realizing those vehicles, such as secondary batteries for driving motors, have been actively developed.

The secondary batteries for driving motors need to have extremely high output characteristics and high energy compared with consumer lithium ion secondary batteries used in mobile phones and notebook personal computers. Accordingly, lithium ion secondary batteries, which have the highest theoretical energy among all batteries, are attracting attention and are now being developed rapidly.

In general, a lithium ion secondary battery has a structure in which a positive electrode where a positive electrode active material and the like is applied on both surfaces of a positive electrode current collector by using a binder, and a negative electrode where a negative electrode active material and the like is applied on both surfaces of a negative electrode current collector by using a binder, are connected via an electrolyte layer, and stored in a battery casing.

Conventionally, carbon and graphite-based materials, which are advantageous in terms of charge-discharge cycle life and costs, have been used for a negative electrode of a lithium ion secondary battery. However, since charge and discharge are carried out by storage and release of lithium ions into graphite crystals in carbon and graphite-based negative electrode materials, there is a shortcoming that it is not possible to have charge-discharge capacity equal to or larger than theoretical capacity of 372 mAh/g, which is obtained from LiC₆, a maximum lithium-introduced compound. Therefore, with carbon and graphite-based negative electrode materials, it is difficult to obtain capacity and energy density that satisfy a practical level for a use on a vehicle.

On the other hand, batteries including negative electrodes made of a material which can be alloyed with Li have higher energy density than that of the conventional batteries employing carbon/graphite-based negative electrode materials. Accordingly, the materials which can be alloyed with Li are expected as the negative electrode materials in vehicle applications. One mole of a Si material, for example, stores and releases 4.4 mole of lithium ions as expressed by the following reaction formula (A). The theoretical capacity of Li₂₂Si₅ (=Li_{4.4}Si) is 2100 mAh/g. The initial capacity per Si weight is as much as 3200 mAh/g (see Sample 42 in reference example C).
[Chem. 1]

Si + 4.4Li⁺+e⁻ ↔ Li_{4.4}Si ... (A)

However, in a lithium ion secondary battery whose negative electrodes are made of a material that can be alloyed with Li, the negative electrodes expand and contract during the processes of charge and discharge. The graphite material expands in volume by about 1.2 times when storing Li ions, for example. On the other hand, the Si material significantly changes in volume (by about 4 times) because Si transits from the amorphous phase to the crystalline phase when Si is alloyed with Li. This could shorten the cycle life of electrodes. Moreover, in the case of the Si negative electrode active material, the capacity is a trade-off for the cycle durability. It is therefore difficult to implement high capacity while improving high cycle durability.

In order to solve such problems, a negative electrode active material for a lithium ion secondary battery has been proposed, which includes an amorphous alloy having a formula; SiₓMᵤAl_{z} (for example, see Japanese Unexamined Patent Application Publication No. 2009-517850). Here, in the formula, x, y, and z show values of atomic percentages where x + y + z = 100, x ≥ 55, y < 22, and z > 0, and M is metal made of at least one kind of Mn, Mo, Nb, W, Ta, Fe, Cu, Ti, V, Cr, Ni, Co, Zr and Y. In the invention described in Patent Literature 1, it is stated in paragraph [0018] that good cycle life is shown in addition to high capacity by minimizing a content of metal M. US 2010/119942 A1 teaches compositions that can provide high energy density active materials for use in negative electrodes of lithium ion batteries. These materials generally comprise silicon and/or tin, and may further comprise carbon and/or zinc as well as other elements in appropriate embodiments. The active materials can have moderate volume changes upon cycling in a lithium ion battery. WO 2013/088846 A1 discloses a negative electrode active material for an electrical device and teaches that the negative electrode active material for an electric device comprises an alloy containing Si in an amount in excess of 23% and less than 64%, 4% to 58% of Sn and Zn in an amount in excess of zero and less than 65%, with the balance being unavoidable impurities.

### SUMMARY OF INVENTION

### TECHNICAL PROBLEM

However, the lithium ion secondary battery whose negative electrodes include an amorphous alloy expressed by the formula SiₓM_{y}Al_{z} described in Patent Literature 1 exhibits good cycle characteristics but does not have sufficient initial capacity. The cycle characteristics are also inadequate.

An object of the present invention is to provide a negative electrode for an electric device such as a Li-ion secondary battery which exhibits balanced characteristics of having high initial capacity and retaining high cycle characteristics.

### SOLUTION TO PROBLEM

The inventors made various studies to solve the aforementioned problem. The inventors found that the above object could be solved by using negative electrodes employing a negative electrode active material composed of a mixture of a predetermined ternary Si alloy and a carbon material, thus completing the invention.

The present invention relates to a negative electrode for an electric device, including: a current collector; and an electrode layer containing a negative electrode active material, an electrically-conductive auxiliary agent and a binder and formed on a surface of the current collector. The negative electrode active material is a mixture of a carbon material and an alloy (hereinafter, just referred to as an alloy or Si alloy) represented by the following formula (1):
[Chem. 2]

SiₓZn_{y}M_{z}Aₐ ... (1)

In formula (1), M is Sn. A is inevitable impurity. x, y, z and a represent mass percent values and satisfy 23 < x < 64, 2 < y < 65, 4 ≤ z < 34, and 0 ≤ a < 0.5, and x + y + z + a = 100;
or the x, y, z and a satisfy 23 < x < 44, 0 < y < 65, 34 < z < 58, and 0 ≤ a < 0.5, and x + y + z + a = 100. The alloy has an average particle diameter smaller than that of the carbon material.

### BRIEF DESCRIPTION OF DRAWINGS

[Fig. 1] Fig. 1 is a schematic cross-sectional view schematically showing an outline of a laminate-type flat non-bipolar lithium ion secondary battery that is a typical embodiment of an electric device according to the present invention;
[Fig. 2] Fig. 2 is a perspective view schematically showing an appearance of the laminate-type flat lithium ion secondary battery that is a typical embodiment of the electric device according to the present invention;
[Fig. 3] Fig. 3 is a ternary composition diagram in which alloy components deposited in reference examples A are plotted and shown together with a composition range of a Si-Zn-V-based alloy that forms a negative electrode active material included in a negative electrode for an electric device not falling under the scope of the present invention;
[Fig. 4] Fig. 4 is a ternary composition diagram, which shows a suitable composition range of the Si-Zn-V-based alloy that forms the negative electrode active material included in the negative electrode for an electric device not falling under the scope of the present invention;
[Fig. 5] Fig. 5 is a ternary composition diagram in which alloy components deposited in reference examples B are plotted and shown together with a composition range of a Si-Zn-Sn-based alloy that forms a negative electrode active material included in a negative electrode for an electric device not falling under the scope of the present invention;
[Fig. 6] Fig. 6 is a ternary composition diagram, which shows a suitable composition range of the Si-Zn-Sn-based alloy that forms the negative electrode active material included in the negative electrode for an electric device according to the present invention;
[Fig. 7] Fig. 7 is a ternary composition diagram, which shows a more suitable composition range of the Si-Zn-Sn-based alloy that forms the negative electrode active material included in the negative electrode for an electric device according to the present invention;
[Fig. 8] Fig. 8 is a ternary composition diagram, which shows an even more suitable composition range of the Si-Zn-Sn-based alloy that forms the negative electrode active material included in the negative electrode for an electric device according to the present invention;
[Fig. 9] Fig. 9 is a view showing an influence of a negative electrode active material alloy composition on initial discharge capacity of batteries obtained in reference examples B of the present invention;
[Fig. 10] Fig. 10 is a view showing a relation between a discharge capacity retention rate in the 50th cycle in the batteries obtained in the reference examples B of the present invention, and the negative electrode active material alloy composition;
[Fig. 11] Fig. 11 is a view showing a relation between a discharge capacity retention rate in the 100th cycle in the batteries obtained in the reference examples B of the present invention, and the negative electrode active material alloy composition;
[Fig. 12] Fig. 12 is a composition diagram of a Si-Zn-Al-based ternary alloy, in which discharge capacities (mAh/g) of batteries using respective samples (sample number 1-48) in the 1 st cycle carried out in reference examples C not falling under the scope of the present invention are classified by color (intensity of color) and plotted;
[Fig. 13] Fig. 13 is a composition diagram of the Si-Zn-Al-based ternary alloy, in which sizes the discharge capacity retention rates (%) of the batteries using the respective samples (sample number 1-48) in the 50th cycle carried out in reference examples C not falling under the scope of the present invention are classified by color (intensity of color) and plotted;
[Fig. 14] Fig. 14 is a view in which composition ranges of the Si-Zn-Al alloy samples of the reference examples C are classified by color (intensity of color) and surrounded in the composition diagram of the Si-Zn-Al-based ternary alloy shown in Fig. 12. In this view, 0.21 ≤ Si (wt%/100) < 1.00, 0 < Zn (wt%/100) < 0.79, and 0 < Al (wt%/100) < 0.79;
[Fig. 15] Fig. 15 is a view in which preferred composition ranges among those of the Si-Zn-Al alloy samples of the reference examples C are classified by color (intensity of color) and surrounded in the composition diagram of the Si-Zn-Al-based ternary alloy shown in Fig. 13. In this view, 0.26 ≤ Si (wt%/100) ≤ 0.78, 0.16 ≤ Zn (wt%/100) ≤ 0.69, and 0 < Al (wt%/100) ≤ 0.51;
[Fig. 16] Fig. 16 is a view in which more preferred composition ranges among those of the Si-Zn-Al alloy samples of the reference examples C are classified by color (intensity of color) and surrounded in the composition diagram of the Si-Zn-Al-based ternary alloy shown in Fig. 13. In the view, 0.26 ≤ Si (wt%/100) ≤ 0.66, 0.16 ≤ Zn (wt%/100) ≤ 0.69, and 0.02 ≤ Al (wt%/100) ≤ 0.51;
[Fig. 17] Fig. 17 is a view in which especially preferred composition ranges among those of the Si-Zn-Al alloy samples of the reference examples C are classified by color (intensity of color) and surrounded in the composition diagram of the Si-Zn-Al-based ternary alloy shown in Fig. 13. In the view, 0.26 ≤ Si (wt%/100) ≤ 0.47, 0.18 ≤ Zn (wt%/100) < 0.44, and 0.22 ≤ Al (wt%/100) ≤ 0.46;
[Fig. 18] Fig. 18 is a view showing dQ/dV curves in discharge processes in the 1st cycles (initial cycles) of batteries carried out by using the respective samples of pure Si (Sample 42) and a Si-Zn-Al-based ternary alloy (Sample 14) in reference examples C;
[Fig. 19] Fig. 19 is a view showing charge-discharge curves, that are respective charge curves in charge processes up to the 50th cycle, and respective discharge curves in discharge processes carried out with a cell for evaluation (CR2032 coin cell) using an electrode for evaluation of the Si-Zn-Al-based ternary alloy (Sample 14) in reference examples C. Arrows from an "early stage" to a "late stage" in the view show directions in which the charge-discharge cycle curves change from the 1 st cycle (early stage) to the 50th cycle (late stage);
[Fig. 20] Fig. 20 is a ternary composition diagram in which alloy components deposited in reference examples D are plotted and shown together with Si-Zn-C-based alloy that forms a negative electrode active material included in a negative electrode for an electric device not falling under the scope of the present invention;
[Fig. 21] Fig. 21 is a ternary composition diagram which shows a suitable composition range of the alloy components of the Si-Zn-C-based alloy that forms the negative electrode active material included in the negative electrode for an electric device not falling under the scope of the present invention; and
[Fig. 22] Fig. 22 is a view showing a relation between a content rate of a Si alloy and energy density or a discharge capacity retention rate in examples.

### DESCRIPTION OF EMBODIMENTS

As described above, the present invention is characterized by using a negative electrode employing a negative electrode active material composed of a mixture of a predetermined ternary Si alloy (a ternary Si-Zn-M alloy) and a carbon material.

According to the present invention, the ternary Si-Zn-M alloy is applied. This can provide an action of reducing the amorphous to crystalline phase transition in the alloying process of Si and Li to increase the cycle life. Moreover, the alloy is mixed with a graphite material. This can provide an action of preventing uneven reaction of the Si alloy within the electrode layer (negative electrode active material) with Li ions to increase the cycle durability. By the aforementioned complex actions, it is possible to provide such a useful effect that the negative electrode for an electric device according to the present invention provides high initial capacity and provides high capacity and high cycle durability.

Hereinafter, a description is given of an embodiment of the negative electrode for an electric device of the present invention and an electric device using the same with reference to the drawings. The technical scope of the present invention should be defined based on the description of claims and is not limited to the following embodiment. In the description of the drawings, the same components are given the same reference numerals, and overlapping description is omitted. The dimensional proportions in the drawings are exaggerated for convenience of explanation and are different from actual proportions in some cases. In the present invention, an "electrode layer" refers to a mixture layer containing a negative electrode active material, an electrically-conductive auxiliary agent, and a binder and is also referred to as a negative electrode active material layer in the description of the specification. The electrode layer of each positive electrode is also referred to as a positive electrode active material layer.

Hereinafter, the basic configuration of the electric device to which the negative electrode for an electric device of the present invention is applicable is described using the drawings. The electric device shown in the embodiment by way of example is a lithium ion secondary battery.

First, in a negative electrode for a lithium ion secondary battery as a typical embodiment of the negative electrode for an electric device according to the present invention and a lithium ion secondary battery employing the same, cells (single cell layers) have high voltage. The lithium ion secondary battery therefore achieves high energy density and high output density. The lithium ion secondary battery including the negative electrode for a lithium ion secondary battery of the embodiment is therefore excellent as a driving power supply or auxiliary power supply for vehicles and can be desirably used as lithium ion secondary batteries for vehicle driving power supply and the like. In addition, the lithium ion secondary battery of the embodiment is adequately applicable to lithium ion secondary batteries for mobile devices such as mobile phones.

In other words, the lithium ion secondary battery which is a target of the embodiment only needs to include the negative electrode for a lithium ion secondary battery of the embodiment described below, and the other constituent requirements should not be particularly limited.

When lithium ion secondary batteries are classified by the style and structure, for example, the negative electrode of the embodiment is applicable to every known style and structure of laminate-type (flat) batteries and winding-type (cylindrical) batteries. When the laminate-type (flat) battery structure is employed, long-term reliability is ensured by a sealing technique such as simple thermocompression. The laminated battery structure is advantageous in terms of cost and workability.

Classifying lithium ion secondary batteries by the electric connection manner (electrode structure), the present invention is applicable to both non-bipolar type (inner parallel connection type) batteries and bipolar type (inner serial connection type) batteries.

If lithium ion secondary batteries are classified by the type of electrolyte layers thereof, the negative electrode of the embodiment is applicable to batteries including conventionally-known types of electrolyte layers, such as liquid electrolyte batteries whose electrolyte layers are composed of liquid electrolyte such as non-aqueous electrolyte liquid and polymer batteries whose electrolyte layers are composed of polymer electrolyte. The polymer batteries are further classified into gel electrolyte batteries employing polymer gel electrolyte (also just referred to as gel electrolyte) and solid polymer (all-solid-state) batteries employing polymer solid electrolyte (also just referred to as polymer electrolyte).

In the following description, a non-bipolar (inner parallel connection type) lithium ion secondary battery including the negative electrode for a lithium ion secondary battery of the embodiment is briefly described using the drawings. The technical scope of the lithium ion secondary battery of the embodiment is not limited to the following description.

### <Entire Structure of Battery>

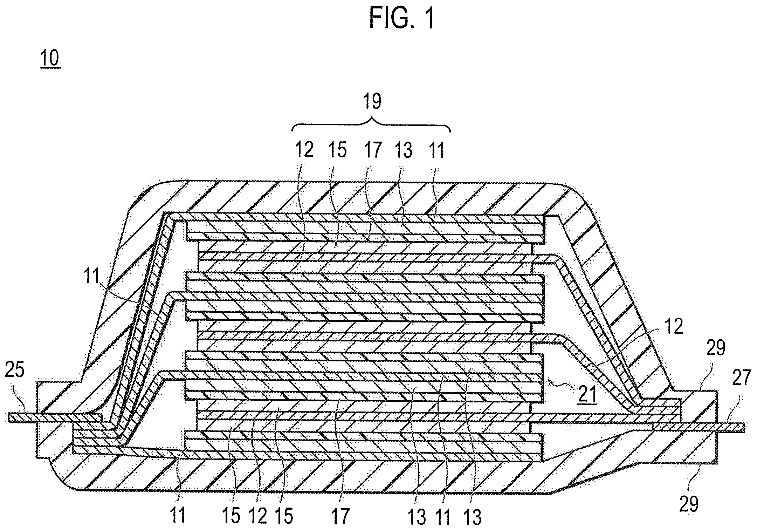

Fig. 1 is a schematic cross-sectional view schematically illustrating the entire structure of a flat (laminate-type) lithium ion secondary battery (hereinafter, also referred to as just a laminated battery) as a typical embodiment of the electric device of the present invention.

As illustrated in Fig. 1, a laminated battery 10 of the embodiment has a structure in which a substantially rectangular power generation element 21, in which charging and discharging reactions actually proceed, is sealed between laminated sheets 29 as a battery exterior member. The power generation element 21 has a configuration in which positive electrodes, electrolyte layers 17, and negative electrodes are stacked on one another. Each positive electrode includes a positive electrode current collector 11 and positive electrode active material layers 13 provided on both surfaces of the current collector 11. Each negative electrode includes a negative electrode current collector 12 and negative electrode active material layers 15 formed on both surfaces of the current collector 12. Specifically, each positive electrode, electrolyte layer, and negative electrode are stacked on one another in this order in such a manner that each of the positive electrode active material layers 13 faces the negative electrode active material layer 15 adjacent thereto with the corresponding electrolyte layer 17 interposed therebetween.

The adjacent positive electrode, electrolyte layer, and negative electrode constitute each single cell layer 19. In other words, the laminated battery 10 illustrated in Fig. 1 has such a configuration that the plural single cell layers 19 are stacked on one another to be electrically connected in parallel. Each of the outermost positive electrode current collectors which are located in the outermost layers of the power generation element 21 is provided with the active material layer 13 on only one side thereof but may be provided with the active material layers on both sides. In other words, the outermost layers may be just composed of current collectors each provided with active material layers on both sides instead of the outermost layer-dedicated current collectors each provided with an active material layer only on one side. The positions of the positive electrodes and negative electrodes in Fig. 1 may be inverted so that the outermost negative electrode current collectors are located in both outermost layers of the power generation element 21 and are each provided with a negative electrode active material layer on one side or on both sides.

The positive electrode current collectors 11 and negative electrode current collectors 12 are respectively attached to a positive electrode current collecting plate 25 and a negative electrode current collecting plate 27, which are electrically connected to respective electrodes (positive and negative electrodes). The current collecting plates 25 and 27 are sandwiched by edges of the laminated films 29 and protrude out of the laminated films 29. The positive and negative electrode current collecting plates 25 and 27 may be attached to the positive and negative electrode current collectors 11 and 12 of the respective electrodes through positive and negative electrode leads (not shown) by ultrasonic welding, resistance welding, or the like if necessary.

The lithium ion secondary battery described above is characterized by the negative electrodes. Hereinafter, the description is given of main constituent members of the battery including the negative electrodes.

### <Active Material layer>

The active material layers 13 and 15 include active materials and further include other additives when needed.

### [Positive Electrode Active Material Layer]

The positive electrode active material layer 13 includes a positive electrode active material.

### (Positive electrode active material)

Examples of the positive electrode active material are lithium-transition metal composite oxides, lithium-transition metal phosphate compounds, lithium-transition metal sulfate compounds, solid solution alloys, ternary alloys, NiMn alloys, NiCo alloys, and spinel Mn alloys.

Examples of the lithium-transition metal composite oxides are LiMn₂O₄, LiCoO₂, LiNiO₂, Li(Ni, Mn, Co)O₂, Li(Li, Ni, Mn, Co)O₂, LiFePO₄, and oxides obtained by replacing a part of the above transition metal with another element.

The solid solution alloys include xLiMO₂·(1-x)Li₂No₃ (0 < x < 1, M is at least one type of transition metals having an average oxidation state of 3+, and N is at least one type of transition metals having an average oxidation state of 4+), LiRO₂-LiMn₂O₄ (R is a transition metal element including Ni, Mn, Co, and Fe), and the like.

The ternary alloys include nickel-cobalt-manganese (composite) positive electrode materials and the like.

The NiMn alloys include LiNi_{0.5}Mn_{1.5}O₄ and the like.

The NiCo alloys include Li(NiCo)O₂ and the like.

The spinel Mn alloys include LiMn₂O₄ and the like.

In some cases, two or more types of positive electrode active materials may be used together. The positive electrode active material is preferably a lithium-transition metal composite oxide from the viewpoint of the capacity and output characteristics. It is certain that positive electrode active materials other than the aforementioned materials can be used. When the optimal particle diameters of active materials to exert the specific effects are different from each other, the different particle diameters optimal to exert the specific effects may be mixed. It is unnecessary to equalize the particle diameters of all the active materials.

The average particle diameter of the positive electrode active materials contained in the positive electrode active material layer 13 is not particularly limited but is preferably 1 to 30 µm and more preferably 5 to 20 µm from the viewpoint of increasing the output. In this specification, the particle diameter refers to the maximum distance between arbitrary two points on the outline of an active material particle (in the observation surface) observed using an observation means, such as a scanning electron microscope (SEM) or a transmission electron microscope (TEM). In the specification, the value of the "average particle diameter" is a value calculated as an average of particle diameters of particles observed in several to several tens fields of view by using an observation means, such as a scanning electron microscope (SEM) or a transmission electron microscope (TEM). The particle diameters and average particle diameters of the other constituent components are defined in a similar manner.

The positive electrode (positive electrode active material layer) can be formed by a normal method of applying (coating with) slurry and can be also formed by any one of kneading, sputtering, vapor deposition, CVD, PVD, ion plating, and thermal spraying.

### [Negative Electrode Active Material Layer]

The negative electrode active material layer 15 includes a negative electrode active material.

### (Negative electrode active material)

The negative electrode active material is a mixture of a predetermined alloy and a carbon material.

### Alloy

In the embodiment, the alloy is expressed by chemical formula (1) below.
[Chem. 3]

SiₓZn_{y}M_{z}Aₐ ... (1)

In the above formula (1), M can be at least one metal selected from the group consisting of V, Sn, Al, C and combinations thereof, wherein only M being Sn falls under the scope of the present invention. A is inevitable impurities. x, y, z and a represent mass percent values, and, in this case, x, y, z and a satisfy 23 < x < 64, 2 < y < 65, 4 ≤ z < 34, and 0 ≤ a < 0.5, and x + y + z + a = 100; or the x, y, z and a satisfy 23 < x < 44, 0 < y < 65, 34 < z < 58, and 0 ≤ a < 0.5, and x + y + z + a = 100,
wherein the alloy has an average particle diameter smaller than that of the carbon material. In the specification, the inevitable impurities refer to substances which exist in raw materials of the Si alloy or substances unavoidably mixed into the Si alloy in the manufacturing process. The inevitable impurities are unnecessary under normal conditions but are allowable because the content thereof is not high enough to influence on the characteristics of the Si alloy.

In this embodiment, by selecting Zn, which is a first additive element, and M (at least one metal selected from the group consisting of V, Sn, Al, C and combinations thereof), which is a second additive element, as the negative electrode active material, it is possible to suppress amorphous-crystalline phase transition at the time of Li alloying, thereby improving cycle life. Further, because of this, the negative electrode active material has higher capacity compared to conventional negative electrode active materials such as a carbon-based negative electrode active material.

Amorphous-crystalline phase transition is suppressed at the time of Li alloying because, when Si and Li are alloyed, a Si material is changed from an amorphous state to a crystalline state and a large volume change (approximately 4 times) happens, thereby causing decay of particles themselves and a loss of functions as an active material. Therefore, by suppressing amorphous-crystalline phase transition, it is possible to suppress decay of particles themselves and maintain functions (high capacity) of the active material, thereby improving cycle life. By selecting the first and second additive elements, it is possible to provide a Si alloy negative electrode active material having high capacity and high cycle durability.

As stated earlier, M can be at least one metal selected from the group consisting of V, Sn, Al, C and combinations thereof, wherein only M being Sn falls under the scope of the present invention. Each of Si alloys SiₓZn_{y}V_{z}Aₐ, SiₓZn_{y}Sn_{z}Aₐ, SiₓZn_{y}Al_{z}Aₐ, and Si_{z}Zn_{y}C_{z}Aₐ is explained below.

### (Si alloy expressed by SiₓZn_{y}V_{z}Aₐ) - not falling under the scope of the present invention

As stated earlier, in SiₓZn_{y}V_{z}Aₐ, stated above, by selecting Zn serving as the first additive element and V serving as the second additive element, it is possible to suppress amorphous-crystalline phase transition at the time of Li alloying, thereby improving cycle life. Also, because of this, SiₓZn_{y}V_{z}Aₐ becomes a negative electrode active material with higher capacity compared to those of conventional negative electrode active materials such as a carbon-based negative electrode active material.

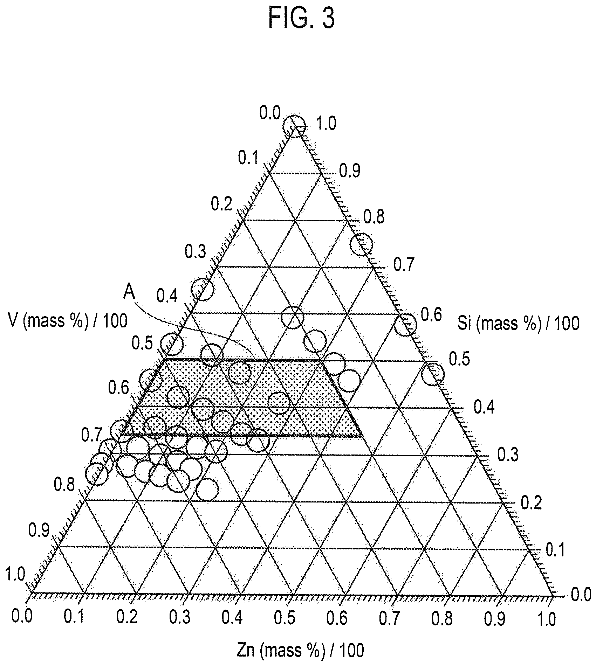

In the composition of the above-mentioned alloy, it is preferred that x is 33-50, y is more than 0 and not more than 46, and z is 21-67. This numerical value range corresponds to a range shown by reference character A in Fig. 3. Also, this Si alloy negative electrode active material is used for a negative electrode of an electric device, for example, a negative electrode of a lithium ion secondary battery. In this case, the alloy contained in the above negative electrode active material absorbs lithium ions when the battery is charged, and releases lithium ions when discharging.

To explain in more detail, the negative electrode active material is a Si alloy negative electrode active material to which zinc (Zn), which is the first additive element, and vanadium (V), which is the second additive element, are added. By appropriately selecting Zn, which is the first additive element, and V, which is the second additive element, it is possible to suppress amorphous-crystalline phase transition when alloying with Lithium, thereby improving cycle life. Due to this, it is also possible to provide higher capacity than that of a carbon-based negative electrode active material. Then, by optimizing composition ranges of Zn and V, which are the first and second additive elements, respectively, it is possible to obtain a Si (Si-Zn-V-based) alloy negative electrode active material with good cycle life even after the 50th cycle.

At this time, in the above-mentioned negative electrode active material made of a Si-Zn-V-based alloy, in the case where the above-mentioned x is not less than 33, the above-mentioned y is more than 0, and the above-mentioned z is not more than 67, it is possible to sufficiently ensure initial capacity. In the case where the above-mentioned x is not more than 50, the above-mentioned y is not more than 46, the above-mentioned x is not less than 21, it is possible to achieve good cycle life.

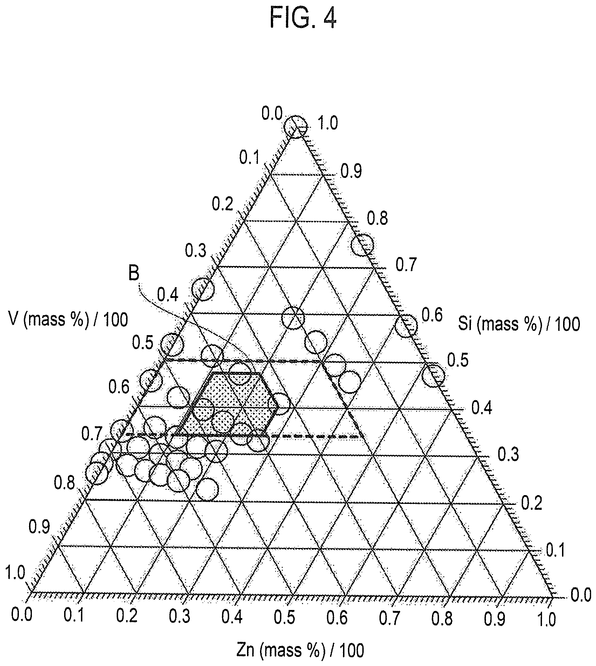

From viewpoint of further improving the above-mentioned characteristics of the negative electrode active material, it is further preferred that the above-mentioned x is in a range of 33-47, y is in a range of 11-27, and z is in a range of 33-56. The numerical value ranges correspond to the range shown by reference character B in Fig. 4.

As stated earlier, A represents impurities (inevitable impurities) derived from a raw material and manufacturing method, other than the above-mentioned three components. The above-mentioned a is 0 ≤ a < 0.5, and 0 ≤ a < 0.1 is preferred.

### (Si alloy expressed by SiₓZn_{y}Sn_{z}Aₐ)

As stated earlier, in the above-mentioned SiₓZn_{y}Sn_{z}Aₐ, by selecting Zn serving as the first additive element and Sn serving as the second additive element, it is possible to suppress amorphous-crystalline phase transition at the time of Li alloying, thereby improving cycle life. Also, because of this, SiₓZn_{y}Sn_{z}Aₐ becomes a negative electrode active material with higher capacity compared to those of conventional negative electrode active materials such as a carbon-based negative electrode active material.

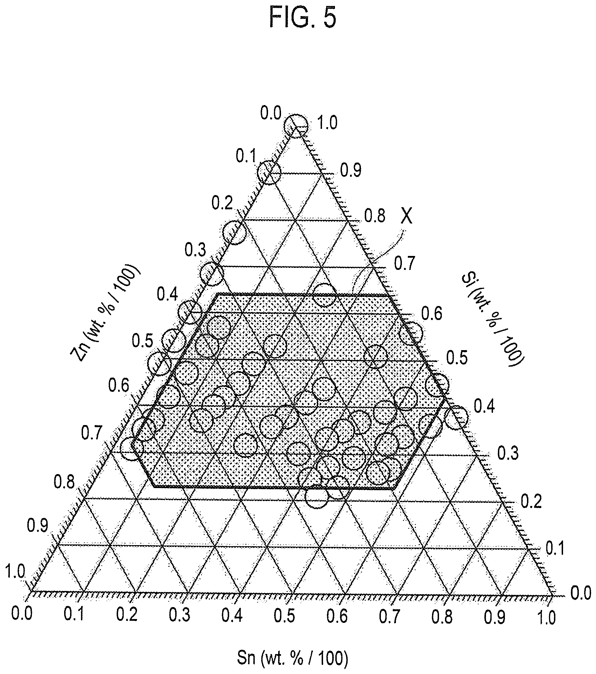

In the composition of the above-mentioned alloy, x is more than 23 and less than 64, y is more than 2 and less than 65, and z is not less than 4 and not more than 34 or x is more than 23 and less than 44, y is more than 0 and less than 65, and z is not less than 34 and not more than 58. This numerical value range of x being more than 23 and less than 64, y being more than 0 and less than 65, and z being not less than 4 and not more than 58 corresponds to a range shown by reference character X in Fig. 5. Also, this Si alloy negative electrode active material is used for a negative electrode of an electric device, for example, a negative electrode of a lithium ion secondary battery. In this case, the alloy contained in the above negative electrode active material absorbs lithium ions when the battery is charged, and releases lithium ions when discharging.

To explain in more detail, the above-mentioned negative electrode active material is a Si alloy negative electrode active material to which zinc (Zn), which is the first additive element, and tin (Sn), which is the second additive element, are added. By appropriately selecting Zn, which is the first additive element, and Sn, which is the second additive element, it is possible to suppress amorphous-crystalline phase transition when alloying with lithium, thereby improving cycle life. Due to this, it is also possible to provide higher capacity than that of a carbon-based negative electrode active material.

Then, by optimizing composition ranges of Zn and Sn, which are the first and second additive elements, respectively, it is possible to obtain a Si (Si-Zn-Sn-based) alloy negative electrode active material with good cycle life even after the 50th cycle and the 100th cycle.

At this time, in the above-mentioned negative electrode active material made of a Si-Zn-Sn-based alloy, in the case where the above-mentioned x is more than 23, it is possible to sufficiently ensure initial capacity in the 1st cycle. In the case where the above-mentioned z is not less than 4, it is possible to sufficiently ensure a good discharge capacity retention rate in the 50th cycle. As long as the above-mentioned x, y, and z are within the foregoing composition range, it is possible to improve cycle durability and sufficiently ensure a good discharge capacity retention rate (for example, 50% or higher) in the 100th cycle.

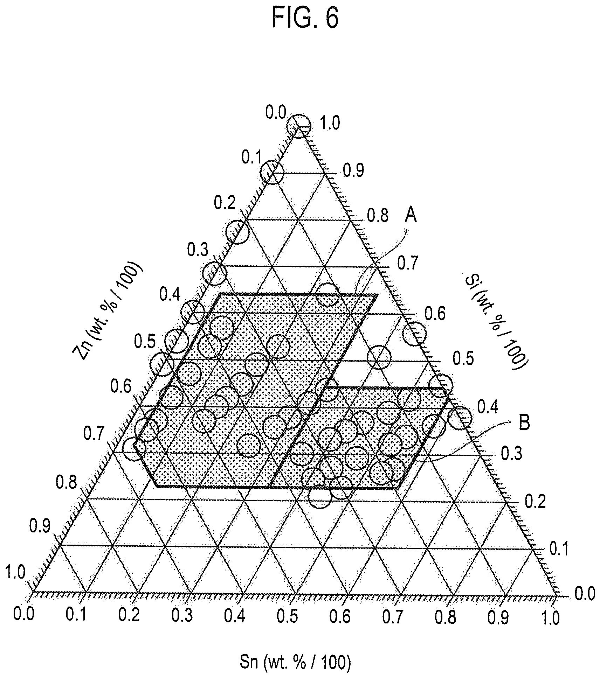

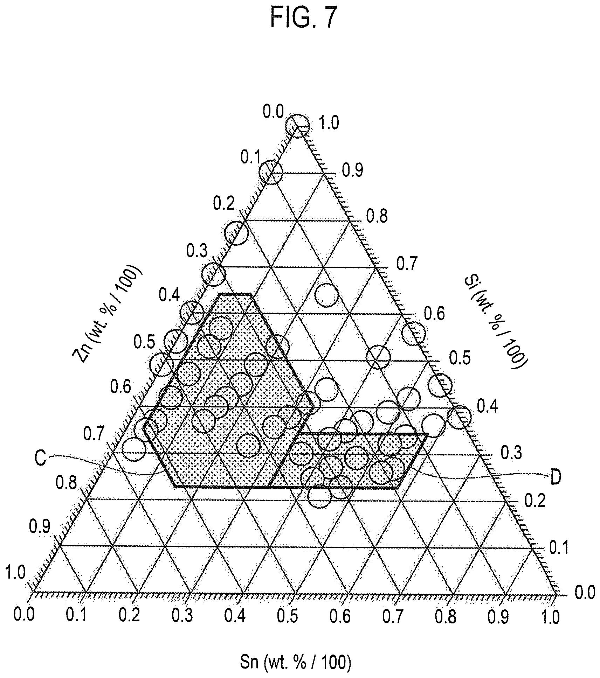

From viewpoint of further improving the above-mentioned characteristics of the Si alloy negative electrode active material, the range shown by reference character A in Fig. 6, expressed by 23 < x < 64, 2 < y < 65, and 4 ≤ z < 34 in the composition of the above-mentioned alloy, is provided. A range shown by reference character B in Fig. 6, which satisfies 23 < x < 44, 0 < y < 43, and 34 < z < 58, is further preferred. Due to this, it is possible to obtain a discharge capacity retention rate that is 90% or higher in the 50th cycle, and higher than 55% in the 100th cycle, as shown in Table 2. From the viewpoint of ensuring better characteristics, a range shown by reference character C in Fig. 7, which satisfies 23 < x <64, 27 < y < 61, and 4 < z < 34, is preferred. Further, a range shown by reference character D in Fig. 7, which satisfies 3 < x < 34, 8 < y < 43, and 34 < z < 58, is preferred. Thus, cycle and durability are improved, and it is possible to obtain a discharge capacity retention rate that exceeds 65% in the 100th cycle as shown in Table 2.

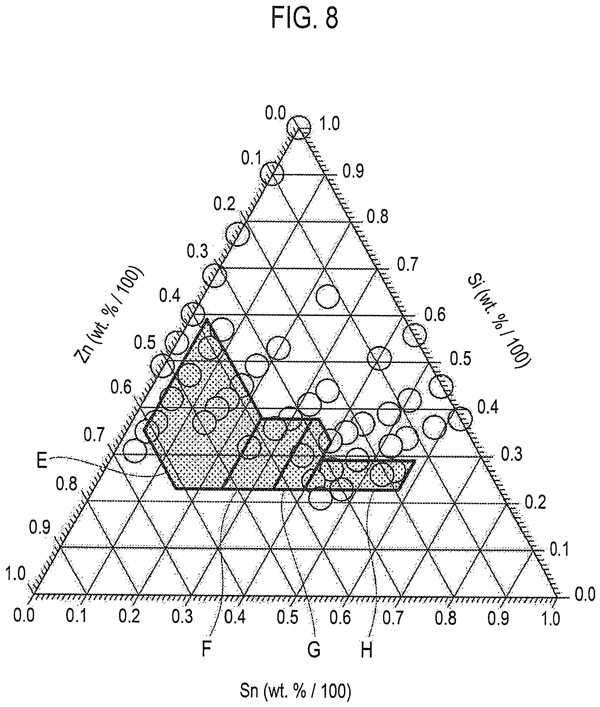

Further, a range shown by reference character E in Fig. 8, which satisfies 23 < x < 58, 38 < y < 61, and 4 < z < 24, a range shown by reference character F in Fig. 8, which satisfies 23 < x < 38, 27 < y < 53, and 24 ≤ z < 35, a range shown by reference character G in Fig. 8, which satisfies 23 < x < 38, 27 < y < 44, and 35 < z < 40, and a range shown by reference character H in Fig. 8, which satisfies 23 < x < 29, 13 < y < 37, and 40 ≤ z < 58, are preferred. Thus, cycle durability is improved, and it is thus possible to obtain a discharge capacity retention rate that exceeds 75% in the 100th cycle as shown in Table 2.

The above-mentioned a is 0 ≤ a < 0.5, and 0 ≤ a < 0.1 is more preferred.

### (Si alloy expressed by SiₓZn_{y}Al_{z}Aₐ) - not falling under the scope of the present invention

As stated earlier, in the above-mentioned SiₓZn_{y}Al_{z}Aₐ, by selecting Zn serving as the first additive element and Al serving as the second additive element, it is possible to suppress amorphous-crystalline phase transition at the time of Li alloying, thereby improving cycle life. Also, because of this, SiₓZn_{y}Al_{z}Aₐ becomes a negative electrode active material with higher capacity compared to those of conventional negative electrode active materials such as a carbon-based negative electrode active material.

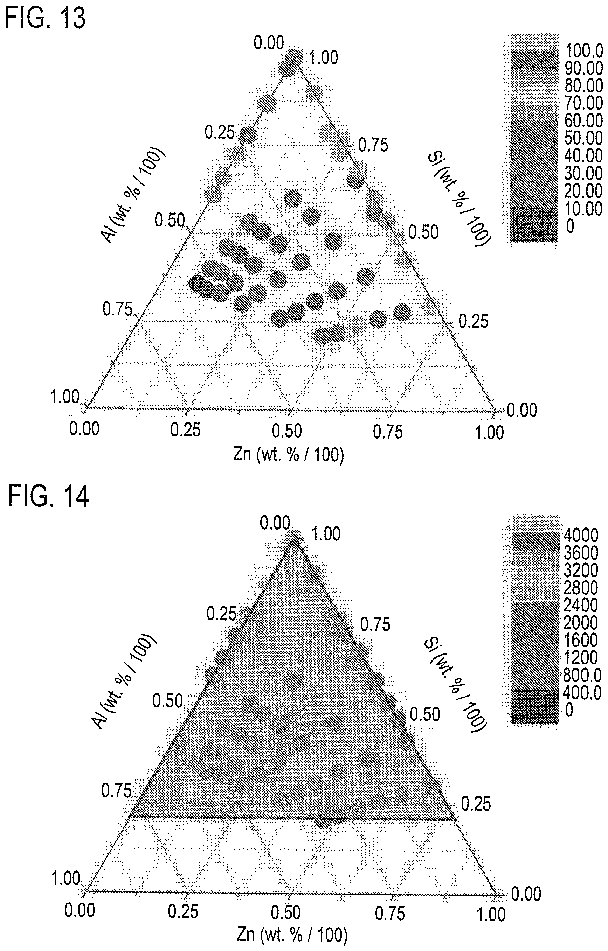

In the composition of the above-mentioned alloy, it is preferred that x, y and z are 21 ≤ x < 100, 0 < y < 79, and 0 < z < 79, respectively. This embodiment having this composition range of the alloy is formed by selecting the first additive element Zn, which suppresses amorphous-crystalline phase transition at the time of Li alloying and thus improve cycle life, and the second additive elemental species Al, which does not reduce capacity as an electrode even if the first additive element concentration increases, and by having an adequate composition ratio of these additional elemental species and a high capacity element Si. The reason why amorphous-crystalline phase transition is suppressed at the time of Li alloying is because, when Si and Li are alloyed, a Si material is changed from an amorphous state to a crystalline state and a large volume change (approximately 4 times) happens, thereby causing decay of particles themselves and a loss of functions as an active material. Therefore, by suppressing amorphous-crystalline phase transition, it is possible to suppress decay of particles themselves and maintain functions (high capacity) as the active material, thereby improving cycle life. By selecting the first and second additive elements and having an adequate composition ratio of these additional elemental species and the high capacity element Si, it is possible to provide the Si alloy negative electrode active material having high capacity and high cycle durability. To be specific, as long as the composition ratio of the Si-Zn-Al alloy is within the above-mentioned range, in a case of inside the range surrounded by a thick solid line in Fig. 14 (inside the triangle), it is possible to realize remarkably high capacity that is not possible to realize with an existing carbon-based negative electrode active material. Similarly, compared to an existing Sn-based alloy negative electrode active material, it is possible to realize higher capacity (initial capacity of 824 mAh/g or higher). Further, regarding cycle durability that is in a trade-off relation with high capacity, it is possible to realize considerably excellent cycle durability compared to a Sn-based negative electrode active material that has high capacity but low cycle durability, and a multicomponent alloy negative electrode active material described in Patent Literature 1. In particular, it is possible to realize a high discharge capacity retention rate in the 50th cycle. Thus, it is possible to provide an excellent Si alloy negative electrode active material.

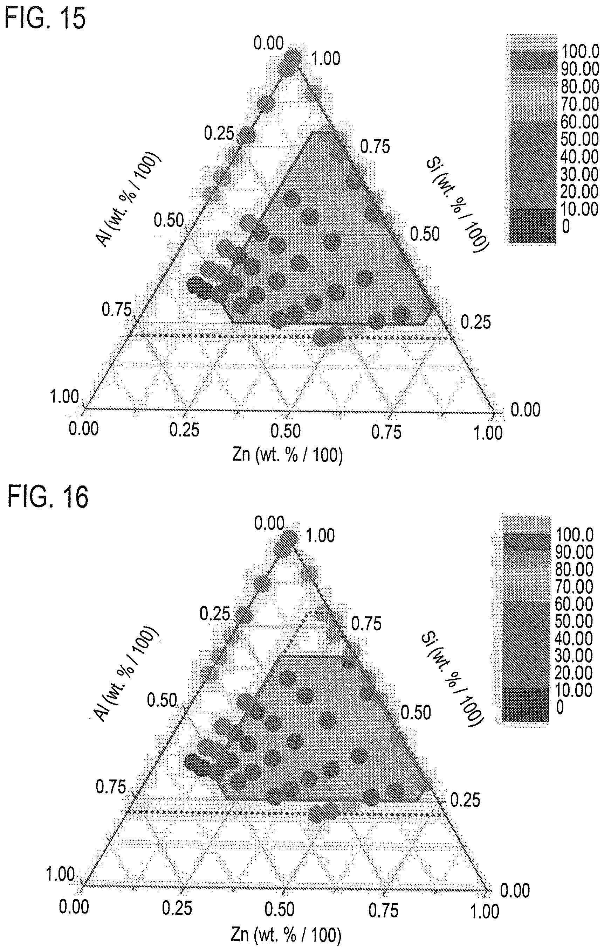

As one embodiment not falling under the scope of the present invention, it is preferred that SiₓZn_{y}Al_{z}Aₐ is characterized in that x, y, and z are 26 ≤ x ≤ 78, 16 ≤ y < 69, and 0 < z ≤ 51. In the case where a composition ratio of Zn, which is the first additive element, Al, which is the second additive element, and the high capacity element Si is in the adequate ranges defined as above, it is possible to provide a Si alloy negative electrode active material having good characteristics. To be specific, in the case where the composition ratio of Si-Zn-Al alloy is within a range surrounded by a thick solid line in Fig. 15 (inner side of the hexagon in Fig. 15), it is possible to realize remarkably high capacity that is not possible to realize with an existing carbon-based negative electrode active material. Similarly, compared to an existing Sn-based alloy negative electrode active material, it is possible to realize higher capacity (initial capacity of 824 mAh/g or higher). Further, regarding cycle durability that is in a trade-off relation with high capacity, it is possible to realize considerably excellent cycle durability compared to a Sn-based negative electrode active material that has high capacity but low cycle durability, and the multicomponent alloy negative electrode active material described in Patent Literature 1. In short, in this case, among composition ratios that are able to specifically realize high capacity in Samples 1-35 of reference examples C, a composition range was selected, which was able to realize remarkably excellent cycle durability compared to the Sn-based negative electrode active material and the multicomponent alloy negative electrode active material described in Patent Literature 1. To be specific, a composition range, which was able to realize a high discharge capacity retention rate of 85% or higher in the 50th cycle (as the hexagon surrounded by the thick solid line in Fig. 15), is selected, it is thus possible to provide an excellent Si alloy negative electrode active material with a good balance between high capacity and cycle durability (see Table 3 and Fig. 15).

As one embodiment not falling under the scope of the present invention, it is more preferred that SiₓZn_{y}Al_{z}Aₐ is characterized in that x, y, and z are 26 ≤ x ≤ 66, 16 ≤ y ≤ 69, and 2 ≤ z ≤ 51, respectively. In this embodiment, in the case where the composition ratio of Zn, which is the first additive element, Al, which is the second additive element, and the high capacity element Si is in the adequate ranges defined as above, it is possible to provide a Si alloy negative electrode active material having very good characteristics. To be specific, in the case where the composition ratio of Si-Zn-Al alloy is within a range surrounded by a thick solid line in Fig. 16 (inner side of the small hexagon), it is also possible to realize remarkably high capacity that is not possible to realize with an existing carbon-based negative electrode active material. Similarly, compared to an existing Sn-based alloy negative electrode active material, it is possible to realize higher capacity (initial capacity of 1072 mAh/g or higher). Further, regarding cycle durability that is in a trade-off relation with high capacity, it is possible to realize considerably excellent cycle durability compared to a Sn-based negative electrode active material that has high capacity but low cycle durability, and the multicomponent alloy negative electrode active material described in Patent Literature 1. To be specific, it is possible to realize a high discharge capacity retention rate of 90% or higher in the 50th cycle. In short, in this case, among Samples 1-35 of reference examples C, only a composition range was selected, which was able to realize a very good balance between high capacity and cycle durability (as the hexagon surrounded by the thick solid line in Fig. 16). Accordingly, it is possible to provide high-performance Si alloy negative electrode active material (see Table 3 and Fig. 16).

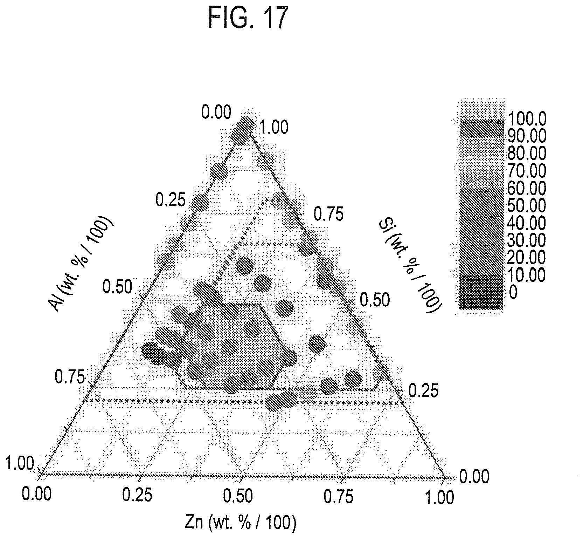

As one embodiment not falling under the scope of the present invention, it is especially preferred that SiₓZn_{y}Al_{z}Aₐ is characterized in that x, y, and z are 26 ≤ x ≤ 47, 18 ≤ y ≤ 44, and 22 ≤ z ≤ 46. In this embodiment, in the case where the composition ratio of Zn, which is the first additive element, Al, which is the second additive element, and a high capacity element Si is in the adequate ranges defined as above, it is possible to provide a Si alloy negative electrode active material having the best characteristics. To be specific, in the case where the composition ratio of the Si-Zn-Al alloy is within a range surrounded by a thick solid line in Fig. 17 (inner side of the smallest hexagon), it is also possible to realize remarkably high capacity that is not possible to realize with an existing carbon-based negative electrode active material. Similarly, compared to an existing Sn-based alloy negative electrode active material, it is possible to realize higher capacity (initial capacity of 1072 mAh/g or higher). Further, regarding cycle durability that is in a trade-off relation with high capacity, it is possible to realize considerably excellent cycle durability compared to those of a Sn-based negative electrode active material that has high capacity but low cycle durability, and the multicomponent alloy negative electrode active material described in Patent Literature 1. To be specific, it is possible to realize a high discharge capacity retention rate of 95% or higher in the 50th cycle. In short, in this case, among Samples 1-35 of reference examples C, only a composition range (the best mode) was selected, which was able to realize the best balance between high capacity and cycle durability (= as the smallest hexagon surrounded by the thick solid line in Fig. 17). Accordingly, it is possible to provide an extremely high-performance Si alloy negative electrode active material (see Table 3 and Fig. 17). Meanwhile, with binary alloys (a Si-Al alloy where y = 0, and a Si-Zn-based alloy where z = 0) that do not contain either one of the additive metal elements to Si in the ternary alloy expressed by Si_{z}Zn_{y}Al_{z}Aₐ, or a simple substance of Si, it is difficult to maintain high cycle characteristics, especially a high discharge capacity retention rate in the 50th cycle. This causes reduction (deterioration) of cycle characteristics, and it has thus not been possible to realize the best balance between high capacity and high cycle durability.

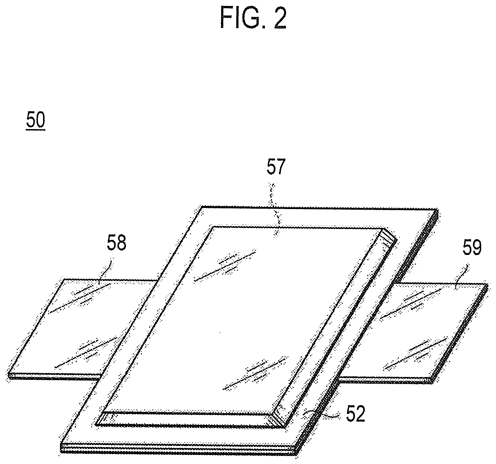

To be in more detail, the Si-Zn-Al-based Si alloy negative electrode active material described above is a ternary amorphous alloy expressed by a composition formula SiₓZn_{y}Al_{z}Aₐ having the adequate composition ratio explained earlier in a manufactured state (an uncharged state). Then, a lithium ion secondary battery, in which the Si-Zn-Al-based Si alloy negative electrode active material is used, has remarkable characteristics by which transfer from an amorphous state to a crystalline state and a large volume change are suppressed when Si and Li are alloyed due to charge and discharge. With other ternary or quaternary alloys expressed by Si_{z}M_{y}Al_{z} in Patent Literature 1, since it is difficult to maintain high cycle characteristics, especially a high discharge capacity retention rate in the 50th cycle, a major problem of rapid decrease (deterioration) of cycle happens. In short, in the ternary and quaternary alloys in Patent Literature 1, the initial capacity (discharge capacity in the 1st cycle) is remarkably higher capacity compared to that of an existing carbon-based negative electrode active material (theoretical capacity of 372 mAh/g), and is also higher capacity compared to the Sn-based negative electrode active material (theoretical capacity of about 600-700 mAh/g). However, the cycle characteristics were not sufficient because a discharge capacity retention rate in the 50th cycle was much lower compared to that of the Sn-based negative electrode active material (about 60%) that is able to increase capacity to about 600-700 mAh/g. In short, balance between high capacity and cycle durability, which are in a trade-off relation, was poor, making it impossible for practical use. To be specific, with the quaternary alloy Si₆₂Al₁₈Fe₁₆Zr₄ in Example 1 of Patent Literature 1, although the initial capacity is as high as about 1150 mAh/g, it is shown that capacity of circulation after only 5-6 cycles is already down to about 1090 mAh/g as in Fig.2 of Patent Literature 1. In other words, in Example 1 of Patent Literature 1, it is shown in the drawing that the discharge capacity retention rate in the 5th-6th cycle is already decreased considerably to about 95%, and the discharge capacity retention rate is reduced by about 1% per cycle. This leads to estimation that the discharge capacity retention rate is decreased by approximately 50% in the 50th cycle (= the discharge capacity retention rate is reduced to about 50%). Similarly, with the ternary alloy Si₅₅Al_{29.3}Fe_{15.7} in Example 2 in Patent Literature 1, although the initial capacity is as high as about 1430 mAh/g, it is shown that capacity of circulation after only 5-6 cycles is already decreased considerably to about 1300 mAh/g in Fig. 4 of Patent Literature 1. In other words, in Example 2 of Patent Literature 1, it is shown in the drawing that the discharge capacity retention rate in the 5th-6th cycle is already decreased considerably to about 90%, and the discharge capacity retention rate is reduced by about 2% per cycle. This leads to estimation that the discharge capacity retention rate is decreased by approximately 100% in the 50th cycle (= the discharge capacity retention rate is reduced to about 0%). For the quaternary alloy Si₆₀Al₂₀Fe₁₂Ti₈ of Example 3 in Patent Literature 1 and the quaternary alloy Si₆₂Al₁₆Fe₁₄Ti₈ of Example 4 in Patent Literature 1, there is no description about initial capacity, but it is shown in Table 2 in Patent Literature 1 that capacity of circulation becomes as low as 700-1200 mAh/g after only 5-6 cycles. In Example 3 in Patent Literature 1, the discharge capacity retention rate in the 5th-6th cycle is about equal or lower than those of Examples 1-2, and it is estimated that the discharge capacity retention rate in the 50th cycle is reduced to about 50%-100% (= the discharge capacity retention rate is decreased to about 50%-0%). Alloy compositions in Patent Literature 1 are stated in atom ratio. Therefore, when converted into a mass ratio, about 20 mass% of Fe is contained in Examples in Patent Literature 1 similarly to this embodiment, and it can thus be said that alloy compositions are disclosed, in which Fe serves as the first additive element.

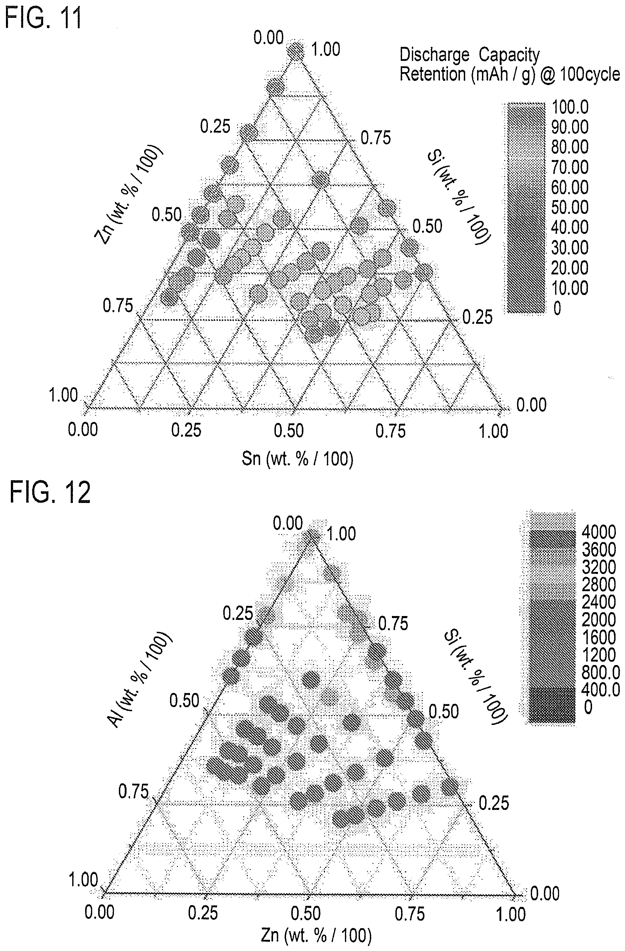

Therefore, batteries using the exiting ternary and quaternary alloys described in Patent Literature 1 have issues in reliability and safety thereof such as not being able to obtain sufficient characteristics that satisfy a practical level in fields like use on a vehicle where cycle durability is strongly required, and practical use of such batteries is thus difficult. Meanwhile, the negative electrode active material using the ternary alloy expressed by composition formula SiₓZn_{y}Al_{z}Aₐ having the adequate composition ratio stated earlier has a high discharge capacity retention rate in the 50th cycle as good cycle characteristics (see Fig. 13). Further, the initial capacity (the discharge capacity in the 1st cycle) is remarkably higher than that of the existing carbon-based negative electrode active material, and is also higher than that of the existing Sn-based negative electrode active material (see Fig. 12), thus making it possible to provide a negative electrode active material that shows good balanced characteristics. Thus, a negative electrode active material was found, which uses an alloy that is able to achieve both characteristics of an increase in capacity and cycle durability at high levels with good balance, even though an increase in capacity and cycle durability are in a trade-off relation and could not be realized with the existing carbon-based and Sn-based negative electrode active materials and the ternary or quarterly alloy described in Patent Literature 1. To be in more detail, it was found that an expected purpose was achievable by selecting two kinds Zn and Al from the group of one or two additional elemental species having large variety of combinations, and further selecting a specific composition ratio (a composition range) of these additional elemental species and high capacity element Si. As a result, the above-mentioned negative electrode active material is superior in that it is possible to provide a lithium ion secondary battery with high capacity and good cycle durability.

The foregoing Si-Zn-Al-based alloy negative electrode active material is explained in detail below.

### (1) Total mass% value of the alloy

The Si-Zn-Al-based alloy stated above is an alloy expressed by the composition formula SiₓZn_{y}Al_{z}Aₐ. In the formula, A represents inevitable impurities. Also, in the formula, x, y, z and a represent mass% values, and, in this case, 0 < x < 100, 0 < y < 100, 0 < z < 100, and 0 ≤ a < 0.5. Then, in the formula, x + y + z + a which is the total mass% of the alloy having the composition formula SiₓZn_{y}Al_{z}Aₐ, equals 100. In short, the Si-Zn-Al-based alloy stated above must be made of a Si-Zn-Al-based ternary alloy. In other words, it can be said that a ternary alloy having other compositions, or quaternary or higher order alloys with another additional metal is not included. However, as stated above, A in the formula, which represents inevitable impurities, could be contained within a range of 0 ≤ a < 0.5. As stated so far, the negative electrode active material layer 15 of this embodiment only needs to contain at least one kind of alloy having the composition formula SiₓZn_{y}Al_{z}Aₐ, and two or more kinds of such alloys having different compositions may also be used together. Further, within a range that does not deteriorate the effects, other negative electrode active material such as a carbon material may be used together.

### (2) Mass% value of Si in the alloy

It is preferred that x in the formula, which is a mass% value of Si in the alloy having the composition formula SiₓZn_{y}Al_{z}Aₐ, is in a range of 21 ≤ x < 100, more preferably 26 ≤ x ≤ 78, even more preferably 26 ≤ x ≤ 66, especially preferably 26 ≤ x ≤ 47 (see Table 3, Fig. 14-Fig. 17). This is because, the higher the numerical value of the mass% value of the high capacity element Si in the alloy becomes, the higher capacity becomes, and, with the preferred range of 21 ≤ x < 100, it is possible to realize a remarkably high capacity (824 mAh/g or higher) that is not possible to realize with the existing carbon-based negative electrode active material. Similarly, it is possible to obtain an alloy with higher capacity compared to the Sn-based negative electrode active material (see Fig. 14). Further, with the range of 21 ≤ x < 100, an excellent discharge capacity retention rate (cycle durability) is realized in the 50th cycle.

More preferably, as the mass% value (x value) of the high capacity element Si in the alloy, the range of 26 ≤ x ≤ 78 is more preferred in terms of providing a negative electrode active material that shows good balanced characteristics where initial capacity is high while maintaining high cycle characteristics (especially a high discharge capacity retention rate in the 50th cycle). In addition, in the case where a later-described composition ratio of Zn serving as the first additive element, and Al serving as the second additive element is adequate, it is possible to realize a Si alloy negative electrode active material having good characteristics (characteristics that both high capacity and cycle durability are excellent, which are in a trade-off relation in the exiting alloy-based negative electrode active material). In short, the larger a mass% value (x value) of the high capacity element Si in alloy is, the higher capacity becomes, but cycle durability tends to be reduced. However, the range of 26 ≤ x ≤ 78 is more preferred in that a high discharge capacity retention rate (85% or higher) can be maintained together with high capacity (1072 mAh/g or higher) (See Table 3 and Fig. 15).

Even more preferably, as the mass% value (x value) of the high capacity element Si in the alloy, it can be said that the range of 26 ≤ x ≤ 66 is even more preferred in terms of providing a negative electrode active material that shows good balanced characteristics where initial capacity is high while maintaining higher cycle characteristics (a higher discharge capacity retention rate). In addition, in the case where a later-described composition ratio of Zn serving as the first additive element, and Al serving as the second additive element is more adequate, it is possible to provide a Si alloy negative electrode active material having better characteristics (see Table 3 and the inner part surrounded by a thick solid line in Fig. 16). In short, the more preferred range of 26 ≤ x ≤ 66 is more excellent in that a higher discharge capacity retention rate (90% or higher) can be maintained in the 50th cycle together with high capacity (1072 mAh/g or higher) (see Table 3 and the inner part surrounded the thick solid line in Fig. 16).

Especially preferably, as the mass% value (x value) of the high capacity element Si in the alloy, it can be said that the range of 26 ≤ x ≤ 47 is especially preferred in terms of providing a negative electrode active material that shows good balanced characteristics where initial capacity is high while maintaining especially high cycle characteristics (an especially high discharge capacity retention rate). In addition, in the case where a later-described composition ratio of Zn serving as the first additive element, and Al serving as the second additive element is more adequate, it is possible to provide a high-performance Si alloy negative electrode active material having the best characteristics (see Table 3 and the inner part surrounded by a thick solid line in Fig. 17). In short, the especially preferred range of 26 ≤ x ≤ 47 is especially excellent in that it is possible to maintain an especially high discharge capacity rate (95% or higher) in the 50th cycle together with high capacity (1072 mAh/g or higher) (see Table 3 and the inner part surrounded by the thick solid line in Fig. 17). Meanwhile, it is not possible to maintain high characteristics with binary alloys (a Si-Al alloy where y = 0, and a Si-Zn-based alloy where z = 0) that do not contain either one of the additive metal elements to Si, in comparison with the ternary alloy expressed by Si_{z}Zn_{y}Al_{z}Aₐ. In particular, it is not possible to sufficiently maintain a high discharge capacity retention rate in the 50th cycle, thus reducing (degradation) cycle characteristics. Therefore, an especially high discharge capacity retention rate is not realized in the best balance with high capacity described above. Also, in the case of x = 100 (in the case of pure Si that does not contain additional metal elements Zn, Al to Si at all), capacity and cycle durability are in a trade-off relation, and it is extremely difficult to improve high cycle durability while showing high capacity. In short, since there is only Si serving as high capacity element, the capacity is the highest, but deterioration as a negative electrode active material is remarkable due to expansion and contraction phenomenon of Si with charge and discharge, and only a very low discharge capacity retention rate is gained. Therefore, an especially high discharge capacity retention rate in the 50th cycle is not realized with the best balance with high capacity stated above.

Here, in the case of x ≥ 26, a content rate (balance) of the Si material having initial capacity as high as 3200 mAh/g, Zn serving as the first additive element, and Al serving as the second additive element can be in an optimum range (see the ranges surrounded by the thick solid lines in Fig. 15-Fig. 17). Therefore, the range of x ≥ 26 is excellent in that it is possible to realize the best characteristics and maintain high capacity stably and safely at the level of use for a vehicle for a long period of time. Meanwhile, in the case of x ≤ 78, especially x ≤ 66, and x ≤ 47 in particular, a content rate (balance) of the high capacity Si material having initial capacity of as high as 3200 mAh/g, Zn serving as the first additive element, and Al serving as the second additive element can be in an optimum range (see the ranges surrounded by the thick solid lines in Fig. 15-Fig. 17). Therefore, it is possible to remarkably suppress amorphous-crystalline phase transition when Si and Li are alloyed, and substantially improve cycle life. In short, it is possible to achieve a discharge capacity retention rate of 85% or higher, especially 90% or higher, and 95% in particular, in the 50th cycle. However, it goes without saying that, even if x is outside the above-mentioned optimum range (26 ≤ x ≤ 78, especially 26 ≤ x ≤ 66, and 26 ≤ x ≤ 47 in particular), it is included in the technical scope (scope of rights) as long as x is in a range that is able to effectively realize the foregoing action effects.

Further, in Examples in Patent Literature 1 stated above, it is disclosed that a deterioration phenomenon of cycle characteristics is observed due to a significant reduction in capacity that is already seen in only about 5-6 cycles. In short, in Examples in Patent Literature 1, the discharge capacity retention rate is already decreased to 90-95% in the 5th-6th cycle, and the discharge capacity retention rate in the 50th cycle is decreased to about 50-0%. Meanwhile, the Si-based alloy stated above was obtained by selecting a combination (only one combination) of Zn serving as the first additive element and Al serving as the second additive element, which are in a mutually complementary relation with each other, for the high capacity Si material after numerous trial and error processes, as well as excessive experiments by using varieties of combinations of additional (metal or non-metal) elements. The Si-based alloy stated above is also superior in that, by further making a content of the high capacity Si material within the optimum ranges stated above in this combination, it is possible to have high capacity and considerably reduce a decrease in a discharge capacity retention rate in the 50th cycle. In short, when Si and Li are alloyed, it is possible to suppress transfer from an amorphous state to a crystalline state due to a remarkably outstanding synergistic action (effect) of the optimum ranges of the Zn serving as the first additive element and Al serving as the second additive element that is in a mutually complementary relation with Zn, thereby preventing a large volume change. Further, the Si-based alloy stated above is excellent in that it is possible to improve high cycle durability of an electrode while showing high capacity (see Table 3 and Fig. 15-Fig. 17).

### (3) Mass% value of Zn in the alloy

It is preferred that y in the formula, which is a mass% value of Zn in the alloy having the composition formula SiₓZn_{y}Al_{z}Aₐ, is in a range of 0 < y < 79, more preferably 16 ≤ y ≤ 69, and especially preferably 18 ≤ y ≤ 44. When the numerical value of the mass% value (y value) of the first additive element Zn in the alloy is in the preferred range of 0 < y < 79, it is possible to effectively suppress amorphous-crystalline phase transition of the high capacity Si material due to characteristics of Zn (and further, characteristics synergistic with Al). As a result, it is possible to realize excellent effects in cycle life (cycle durability), especially a high discharge capacity retention rate in the 50th cycle (85% or higher, especially 90% or higher, or in particular 95% or higher) (see Fig. 15-Fig. 17). In addition, it is possible to hold the numerical value of the content x value of the high capacity Si material at a certain level of higher (21 ≤ x < 100), thus making it possible to realize remarkably high capacity which is not possible to realize with the existing carbon-based negative electrode active material. Similarly, it is possible to obtain an alloy with higher capacity compared to that of the Sn-based alloy negative electrode active material (initial capacity of 824 mAh/g or higher, especially 1072 mAh/g or higher) (see Table 3 and Fig. 15-Fig. 17).

More preferably, as the mass% value (y value) of the first additive element Zn in the alloy, the range of 16 ≤ y ≤ 69 is more preferred in terms of providing a negative electrode active material that shows good balanced characteristics where initial capacity is high while maintaining high cycle characteristics (especially, a high discharge capacity retention rate in the 50th cycle). With an adequate content rate of the first additive element Zn having an action effects of suppressing amorphous-crystalline phase transition at the time of Li alloying and improving cycle life, it is possible to provide a Si alloy negative electrode active material with good characteristics (see Table 3 and composition ranges surrounded by thick solid lines in Fig. 15, Fig. 16). In short, it is preferred that the mass% value (y value) of the first additive element Zn in the alloy is within the more preferred range of 16 ≤ y ≤ 69 because it is possible to effectively realize action effects of suppressing amorphous-crystalline phase transition at the time of Li alloying and improving cycle life, and it is possible to maintain a high discharge capacity retention rate in the 50th cycle (85% or higher, especially 90% or higher) (see Table 3, Fig. 15 and Fig. 16). This is a case where composition ranges (the hexagons surrounded by the thick solid lines in Fig. 15 and Fig. 16) were selected (especially 16 ≤ y ≤ 69 for the Zn content) among Samples 1-35 in reference examples C, with which high capacity was concretely realized. With the above-mentioned composition ranges, especially the selection of 16 ≤ y ≤ 69 for the Zn content, it is possible to provide a Si alloy negative electrode active material that realizes a remarkably higher cycle durability (a discharge capacity retention rate of 85% or higher, especially 90% or higher) compared to the existing Sn-based negative electrode active material or the multicomponent alloy negative electrode active material described in Patent Literature 1 (see Table 3, and Fig. 15, and Fig. 16).

Especially preferably, as the mass% value (y value) of the first additive element Zn in the alloy, the range of 18 ≤ y ≤ 44 is even more preferred in terms of providing a negative electrode active material that shows the best-balanced characteristics where initial capacity is high while maintaining higher cycle characteristics (a high discharge capacity retention rate in the 50th cycle). With an adequate content rate of the first additive element Zn having action effects of suppressing amorphous-crystalline phase transition at the time of Li alloying and improving cycle life, it is possible to provide a Si alloy negative electrode active material having the best characteristics (see Table 3 and Fig. 17). In short, with the especially preferred range of 18 ≤ y ≤ 44, it is possible to more effectively realize the effects of suppressing amorphous-crystalline phase transition at the time of Li alloying and improving cycle life, and maintain a high discharge capacity rate of 95% or higher in the 50th cycle (see Table 3 and Fig. 17). In particular, this is the case where the composition range (the smallest hexagon surrounded by the thick solid line in Fig. 17) was selected (in particular, 18 ≤ y ≤ 44 for the Zn content) among Samples 1-35 of reference examples C, with which an even higher high capacity, and a high discharge capacity retention rate of 95% or higher in the 50th cycle were realized. By selecting the above-mentioned composition range, especially 18 ≤ y ≤ 44 for the Zn content, it is possible to provide a Si alloy negative electrode active material having not only high capacity but also remarkably excellent cycle durability (a higher discharge capacity retention rate) compared to the Sn-based negative electrode active material and the multicomponent alloy negative electrode active material described in Patent Literature 1. Meanwhile, with a binary alloy (especially a Si-Al alloy where y = 0) that does not contain either one of the additive metal elements (Zn, Al) to Si in the ternary alloy expressed by the composition formula SiₓZn_{y}Al_{z}Aₐ, it is not possible to maintain high cycle characteristics. In particular, it is not possible to sufficiently maintain a high discharge capacity retention rate in the 50th cycle, causing (decrease) deterioration of cycle characteristics. Therefore, it is not possible to provide the best-balanced Si alloy negative electrode active material having excellent cycle durability (an especially high discharge capacity retention rate in the 50th cycle) together with the foregoing high capacity.

Here, in the case of y ≥ 16, especially y ≥ 18, the content rates (balance between) the high capacity Si material having initial capacity of as high as 3200 mAh/g, and the first additive element Zn (and also the remaining second additive element Al) can be in optimal ranges (see the ranges surrounded by the thick solid lines in Fig. 15-Fig. 17). Therefore, it is possible to achieve effective suppression of amorphous-crystalline phase transition of the Si material, which is characteristics of Zn (and also characteristics synergistic with Al), thereby remarkably improving cycle life (especially a discharge capacity retention rate). In short, it is possible to realize a discharge capacity retention rate of 85% or higher, especially 90% or higher, and particularly 95% or higher in the 50th cycle. As a result, the Si-based alloy stated above is excellent in that it is possible to maintain the best characteristics as a negative electrode active material (a negative electrode), and high capacity at a level for a use on a vehicle stably and safely over a long period of time. Meanwhile, in the case of y ≤ 69, especially y ≤ 44, the content rate of (balance between) the high capacity Si material having initial capacity as high as 3200 mAh/g, and the first additive element Zn (and also the second additive element Al) can be in optimal ranges (see the ranges surrounded by the thick solid lines in Fig. 15-Fig. 17). Therefore, it is possible suppress amorphous-crystalline phase transition when alloying Si and Li, and remarkably improve cycle life. In short, it is possible to realize a discharge capacity retention rate of 85% or higher, especially 90% or higher, and particularly 95% or higher in the 50th cycle. However, it goes without saying that, even if y is outside the above-mentioned optimum range (16 ≤ y < 69, especially 18 ≤ y ≤ 44), it is included in the technical scope (scope of rights) as long as y is in a range which is able to effectively realize the foregoing action effects.

In Examples described in Patent Literature 1 stated above, it is disclosed that a deterioration phenomenon of cycle characteristics is observed due to a significant reduction in capacity already in only about 5-6 cycles. In short, in Examples in Patent Literature 1, the discharge capacity retention rate is already decreased to 90-95% in the 5th-6th cycle, and the discharge capacity retention rate in the 50th cycle is decreased to about 50-0%. Meanwhile, the Si-based alloy stated above was obtained by selecting (only one combination of) Zn serving as the first additive element for the high capacity Si material (and also a combination with the second additive element Al that is in a mutually complementary relation) after numerous trial and error processes, as well as excessive experiments by using varieties of combinations of additional (metal or non-metal) elements. The Si-based alloy stated above is excellent in that, by further making a content of Zn within the optimum ranges stated above in this combination, it is possible to considerably reduce a decrease in a discharge capacity retention rate in the 50th cycle. In short, when Si and Li are alloyed, it is possible to suppress transfer from an amorphous state to a crystalline state and prevent a large volume change due to a remarkably outstanding synergistic action (effect) of the optimum ranges of the first additive element Zn (and also the second additive element Al that is in a mutually complementary relation with Zn). Further, the Si-based alloy stated above is excellent in that it is possible to improve high cycle durability of an electrode while showing high capacity (see Table 3 and Fig. 15-Fig. 17).

### (4) Mass% value of Al in the alloy

It is preferred that z in the formula, which is a mass% value of Al in the alloy having the composition formula SiₓZn_{y}Al_{z}Aₐ, is 0 < z < 79, more preferably 0 < z ≤ 51, and even more preferably 2 ≤ z ≤ 51, and especially preferably 22 ≤ z ≤ 46. When the numerical value of the mass% value (z value) of the second additive elemental species Al, which causes no reduction in capacity as an electrode even if the first additive element concentration is increased in the alloy, is in the preferred range of 0 < z < 79, it is possible to effectively suppress amorphous-crystalline phase transition of the high capacity Si material due to characteristics of Zn and characteristics synergistic with Al. As a result, it is possible to realize excellent effects in cycle life (cycle durability), especially a high discharge capacity retention rate in the 50th cycle (85% or higher, especially 90% or higher, or in particular 95% or higher) (see Table 3, and Fig. 15 to Fig. 17). In addition, it is possible to hold the numerical value of the x value that is the content of the high capacity Si material at a certain level of higher (21 ≤ x <100), thereby making it possible to realize a remarkably high capacity which is not possible to realize with the existing carbon-based negative electrode active material. Similarly, it is possible to obtain an alloy having a similar or higher capacity to that of the existing Sn-based alloy negative electrode active material (initial capacity of 824 mAh/g or higher, especially 1072 mAh/g or higher) (see Table 3 and Fig. 14-Fig. 17).

More preferably, as the mass% value (z value) of the second additive element Al in the alloy, the range of 0 < z ≤ 51 is more preferred in terms of providing a negative electrode active material that shows good balanced characteristics where initial capacity is high while maintaining high cycle characteristics (especially, a high discharge capacity retention rate in the 50th cycle). It is extremely important and useful to select the first additive element Zn, which suppresses amorphous-crystalline phase transition at the time of Li alloying and improves cycle life, and the second additive element Al, by which capacity is not reduced as an negative electrode active material (a negative electrode) even if a concentration of the first additive element concentration is increased. It was found that, because of the first and second additive elements, a remarkable difference was observed in action effect from those of the conventionally-known ternary alloy or quaternary or higher order alloys in Patent Literature 1 and the like, and binary alloys such as a Si-Zn-based alloy and a Si-Al-based alloy. With an adequate content rate of the second additive element Al (and also the first additive element Zn that is in a mutually complementary relation with Al), a Si alloy negative electrode active material having good characteristics is obtained (see Table 3 and the composition range surrounded by the thick solid line in Fig. 15). In short, when the mass% value (z value) of the second additive element Al in the alloy is within the more preferred range of 0 < z ≤ 51, the effects of suppressing amorphous-crystalline phase transition at the time of alloying and improving cycle life are effectively realized by the synergistic effect (the mutually complementary relation) with the first additive element Zn. As a result, it is possible to maintain a high discharge capacity retention rate in the 50th cycle (85% or higher) (see Table 3 and Fig. 15). This is a case where a composition range (the hexagon surrounded by the thick solid line in Fig. 15) was selected (especially 0 < z ≤ 51 for the Zn content) among Samples 1-35 in reference examples C, with which high capacity was concretely realized. By selecting the above-mentioned composition range, especially 0 < z ≤ 51 for the Zn content, it is possible to realize remarkably higher cycle durability by the synergistic effect (the mutually complementary relation) with the first additive element Zn compared to the existing high capacity Sn-based negative electrode active material and the multicomponent alloy negative electrode active material described in Patent Literature 1. As a result, it is possible to provide a Si alloy negative electrode active material which realizes a discharge capacity retention rate of 85% or higher in the 50th cycle (see Table 3 and the composition range surrounded by the thick solid line in Fig. 15).

More preferably, as the mass% value (z value) of the second additive element Al in the alloy, the range of 2 ≤ z ≤ 51 is preferred in terms of providing a negative electrode active material that shows good balanced characteristics where initial capacity is high while maintaining higher cycle characteristics (a high discharge capacity retention rate in the 50th cycle). This is because it is possible to provide a Si alloy negative electrode active material having even better characteristics in the case of a more adequate content rate of the second additive element Al which is able to achieve effects of suppressing amorphous-crystalline phase transition at the time of Li alloying, and improving cycle life by the synergistic effect (the mutually complementary relation) with the first additive element Zn. In short, with the more preferred range of 2 ≤ z ≤ 51, it is possible to more effectively realize the effects of suppressing amorphous-crystalline phase transition at the time of alloying, and improving cycle life by the synergistic effect (the mutually complementary relation) with Zn. As a result, it is possible to maintain a higher discharge capacity retention rate of 90% or higher in the 50th cycle (see Table 3 and Fig. 16). In particular, this is a case where a composition range (the small hexagon surrounded by the thick solid line in Fig. 16) was selected (especially 2 ≤ z ≤ 51 for the Al content) among Samples 1-35 in reference examples C, by which high capacity and a high discharge capacity retention rate of 90% or higher in the 50th cycle were realized. By selecting the above-mentioned composition range, especially 2 ≤ z ≤51 for the Al content, it is possible to provide a good balanced Si alloy negative electrode active material, which realizes high capacity as well as remarkably higher cycle durability by the synergistic effect with Zn, compared to those of the existing high capacity Sn-based negative electrode active material and the multicomponent alloy negative electrode active material described in Patent Literature 1.

Especially preferably, as the mass% value (z value) of the second additive element Al in the alloy, the range of 22 ≤ z ≤ 46 is preferred in terms of providing a negative electrode active material having the best-balanced characteristics where initial capacity is high while maintaining better cycle characteristics (a high discharge capacity retention rate in the 50th cycle). This is because it is possible to provide a Si alloy negative electrode active material having the best characteristics in the case of the most adequate content rate of the second additive element Al which is able to achieve effects of suppressing amorphous-crystalline phase transition at the time of Li alloying, and improving cycle life by the synergistic effect (the mutually complementary relation) with Zn. In short, with the especially preferred range of 22 ≤ z ≤ 46, it is possible to more effectively realize the effects of suppressing the amorphous-crystalline phase transition at the time of alloying and improving cycle life due to the synergistic effect (mutually complementary relation) with Zn. As a result, it is possible to maintain an even higher discharge capacity retention rate of 95% or higher in the 50th cycle (see Table 3 and Fig. 17). In particular, this is a case where a composition range (the small hexagon surrounded by the thick solid line in Fig. 16) was selected (especially 22 ≤ z ≤ 46 for the Al content) among Samples 1-35 in reference examples C, by which an even higher capacity and a high discharge capacity retention rate of 95% or higher in the 50th cycle were realized. By selecting the above-mentioned composition range, especially 22 ≤ z ≤ 46 for the Al content, it is possible to provide the best-balanced Si alloy negative electrode active material which realizes high capacity as well as remarkably excellent cycle durability by the synergistic effect with Zn, in comparison with those of the existing high-capacity Sn-based negative electrode active material and the multicomponent alloy negative electrode active material described in Patent Literature 1. Meanwhile, with a binary alloy (especially a Si-Al alloy where z = 0) that does not contain either one of the additive metal elements (Zn, Al) to Si in the ternary alloy expressed by the composition formula SiₓZn_{y}Al_{z}Aₐ, it is not possible to maintain high cycle characteristics. In particular, it is not possible to maintain a high discharge capacity retention rate in the 50th cycle, thereby causing a reduction (deterioration) of cycle characteristics. Therefore, it is not possible to provide the best-balanced Si alloy negative electrode active material having excellent cycle durability (an especially high discharge capacity retention rate in the 50th cycle) together with foregoing high capacity.

Here, in the case of z ≥ 2, especially z ≥ 22, the content rate of (balance among) the high capacity Si material having initial capacity as high as 3200 mAh/g, the first additive element Zn, and also the second additive element Al can be in optimal ranges (see the ranges surrounded by the thick solid lines in Fig. 16-Fig. 17). Therefore, it is possible to realize the characteristics of Al, which is effective suppression of a reduction in capacity as a negative electrode active material (a negative electrode) even if a concentration of Zn, which is able to suppress amorphous-crystalline phase transition, is increased, thereby remarkably improving cycle life (especially a discharge capacity retention rate). In short, it is possible to realize a discharge capacity retention rate of 90% or higher, especially 95% or higher in the 50th cycle. As a result, the Si-based alloy stated above is excellent in that it is possible to realize the best characteristics as a negative electrode active material (a negative electrode), and it is possible to maintain high capacity at a level for a use on a vehicle stably and safely for a long period of time. Meanwhile, in the case of z ≤ 51, especially z ≤ 46, a content rate of (balance among) the high capacity Si material having initial capacity as high as 3200 mAh/g, the first additive element Zn, and the second additive element Al can be in an optimum range (see the ranges surrounded by the thick solid lines in Fig. 15 to Fig. 17). Therefore, it is possible to remarkably suppress amorphous-crystalline phase transition when alloying Si and Li, and largely improve cycle life (especially a discharge capacity retention rate in the 50th cycle). In short, it is possible to realize a discharge capacity retention rate of 85% or higher, especially 90% or higher, and particularly 95% or higher in the 50th cycle. However, it goes without saying that, even if z is outside the above-mentioned optimum range (2 ≤ z ≤ 51, especially 22 ≤ z ≤ 46), it is included in the technical scope (scope of rights) as long as z is in a range which is able to effectively realize the foregoing action effects.

In Examples described in Patent Literature 1 above, it is disclosed that a deterioration phenomenon of cycle characteristics is observed due to a significant reduction in capacity already in only about 5-6 cycles. In short, in Examples in Patent Literature 1, the discharge capacity retention rate is already decreased to 90-95% in the 5th-6th cycle, and the discharge capacity retention rate in the 50th cycle is decreased to about 50-0%. Meanwhile, the Si-based alloy stated above was obtained by selecting a combination (only one combination) of the first additive element Zn and the second additive element Al, which are in a mutually complementary relation, for the high capacity Si material, after numerous trial and error processes, as well as excessive experiments by using varieties of combinations of additional (metal or non-metal) elements. The Si-based alloy stated above is also excellent in that, by further making a content of Al within the optimum ranges stated above in this combination, it is possible to considerably reduce a decrease in a discharge capacity retention rate in the 50th cycle. In short, when Si and Li are alloyed, it is possible to suppress transfer from an amorphous state to a crystalline state and prevent a large volume change due to a remarkably outstanding synergistic action (effect) of the optimum range of the second additive element Al (and also the first additive element Zn that is in a mutually complementary relation with Al). Further, the Si-based alloy stated above is excellent in that it is possible to improve high cycle durability of an electrode while showing high capacity.

### (5) Mass% value of A (inevitable impurities) in the alloy

It is preferred that a in the formula, which is a mass% value of A in the alloy having the composition formula SiₓZn_{y}Al_{z}Aₐ, is 0 ≤ a < 0.5, and more preferably 0 ≤ a < 0.1. As stated earlier, in a Si alloy, A exists in raw materials and is inevitably mixed in manufacturing processes. Although being normally unnecessary, the inevitable impurities are permitted to be contained in the alloy because the quantity thereof is very small and does not affect characteristics of the Si alloy.

### (Si alloy expressed by SiₓZn_{y}C_{z}Aₐ) - not falling under the scope of the present invention

As stated earlier, by selecting Zn serving as the first additive element and C serving as the second additive element, the above-mentioned SiₓZn_{y}C_{z}Aₐ is able to suppress amorphous-crystalline phase transition at the time of Li alloying, thereby improving cycle life. Also, because of this, SiₓZn_{y}C_{z}Aₐ becomes a negative electrode active material having higher capacity compared to those of conventional negative electrode active materials such as a carbon-based negative electrode active material.

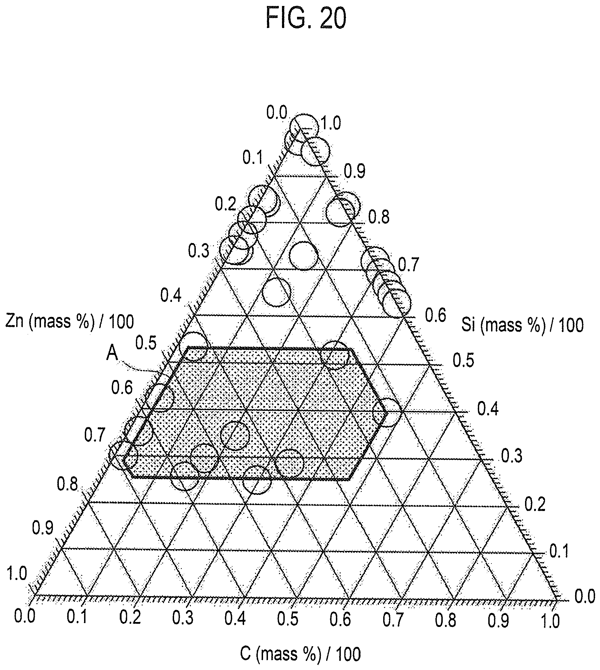

In the composition of the above-mentioned alloy, it is preferred that the above-mentioned x is more than 25 and less than 54, the above-mentioned y is more than 13 and less than 69, and the above-mentioned z is more than 1 and less than 47. This numerical value ranges correspond to the range shown by reference character A in Fig. 20. This Si alloy negative electrode active material is used as a negative electrode of an electric device, for example, a negative electrode of a lithium ion secondary battery. In this case, an alloy contained in the above-mentioned negative electrode active material absorbs lithium ions when the battery is charged, and releases lithium ions when discharging.

To explain in more detail, the above-mentioned negative electrode active material is a Si alloy negative electrode active material to which zinc (Zn), which is the first additive element, and carbon (C), which is the second additive element, are added. By appropriately selecting Zn, which is the first additive element, and C, which is the second additive element, it is possible to suppress amorphous-crystalline phase transition when alloying with Lithium, thereby improving cycle life. Also, because of this, it is possible to provide higher capacity than that of a carbon-based negative electrode active material. Then, by optimizing composition ranges of Zn and C, which are the first and second additive elements, respectively, it is possible to obtain the Si (Si-Zn-C-based) alloy negative electrode active material having good cycle life even after 50 cycles. Further, with the Si (Si-Zn-C-based) alloy negative electrode active material, it is possible to achieve high capacity and high cycle durability, and it is also possible to achieve high charge-discharge efficiency in an early stage.

At this time, in the above-mentioned negative electrode active material made of a Si-Zn-C-based alloy, in the case where the above-mentioned x is more than 25, it is possible to sufficiently ensure discharge capacity in the 1 st cycle. On the other hand, in the case where the above-mentioned x is less than 54, it is possible to realize more excellent cycle characteristics compared to the case of conventional pure Si. Further, in the case where the above-mentioned y is more than 13, it is possible to realize more excellent cycle characteristics compared to the case of conventional pure Si. On the other hand, when the above-mentioned y is less than 69, it is possible to suppress a reduction in Si content, and effectively suppress a reduction of initial capacity, in comparison with a conventional pure Si negative electrode active material, thereby achieving high capacity and high charge-discharge efficiency in an early stage. In the case where the above-mentioned z is more than 1, it is possible to realize more excellent cycle characteristics compared to the case of conventional pure Si. On the other hand, when the above-mentioned z is less than 47, it is possible to suppress a reduction in Si content, and effectively suppress a reduction of initial capacity, in comparison with a conventional pure Si negative electrode active material, thereby achieving high capacity and high charge-discharge efficiency in an early stage.

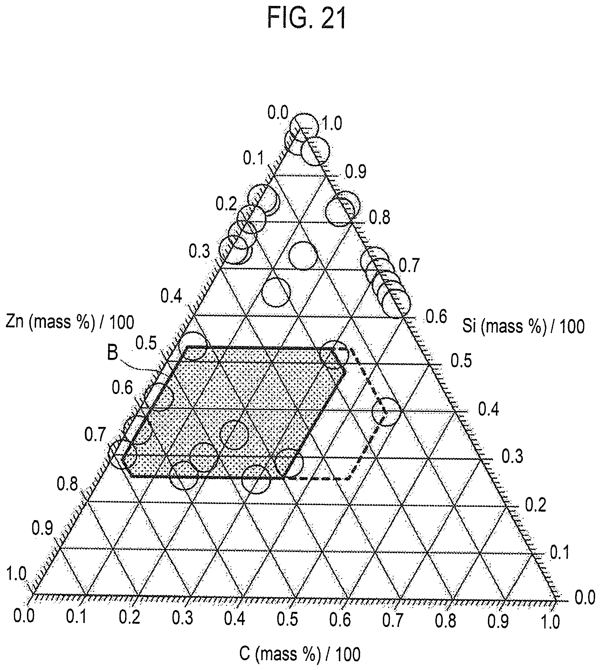

As shown by reference character B in Fig. 21, it is preferred that the above-mentioned z is in a range that is more than 1 and less than 34 in terms of further improving the above-mentioned characteristics of the Si alloy negative electrode active material. In addition, it is preferred that the above-mentioned y is in a range that is more than 17 and less than 69.

The above-mentioned a is 0 ≤ a < 0.5, and 0 ≤ a < 0.1 is preferred.

An average particle diameter of the Si alloy is not particularly limited, and only needs to be about the same as an average particle diameter of a negative electrode active material contained in an existing negative electrode active material layer 15. In terms of a high output, a range of 1-20 µm is preferred. However, an average particle diameter is not particularly limited to the aforementioned range, and it goes without saying that an average particle diameter may be outside the range as long as the action effects of this embodiment are effectively realized. The shape of the Si alloy includes, but not particularly limited to, spherical, elliptic, columnar, polygonal, scale-like, and irregular shapes.

### Manufacturing method for the alloy

A manufacturing method for the alloy having the composition formula SiₓZn_{y}M_{z}Aₐ according to this embodiment is not particularly limited, and various kinds of conventionally known manufacturing methods may be used to manufacture the alloy. In short, every possible preparation method may be applied because there is almost no difference in states and characteristics of the alloy depending on a preparation method.

To be specific, for example, a mechanical alloying method, an arc plasma melting method, and the like may be used as a manufacturing method for a particle form of an alloy having the composition formula SiₓZn_{y}M_{z}Aₐ.

With the aforementioned methods of manufacturing alloy in the form of particles, the particles are mixed with a binder, an electrically-conductive auxiliary agent, and a viscosity modifying solvent to prepare slurry. The slurry is used to form slurry electrodes. Accordingly, the electrodes can be easily mass produced and are excellent in being easily put into practical use as actual electrodes for batteries.

### Carbon material

The carbon material that can be used in the present invention is not particularly limited and can be: graphite as high-crystallinity carbon such as natural graphite and artificial graphite; low-crystallinity carbon such as soft carbon and hard carbon; carbon black such as Ketjenblack, acetylene black, channel black, lamp black, oil furnace black, and thermal black; and carbon materials such as fullerene, carbon nanotubes, carbon nanofibers, carbon nanohorns, and carbon fibrils. Among the aforementioned materials, graphite is preferably used.

In the embodiment, the negative electrode active material is a mixture of the carbon material and the aforementioned alloy. This can implement a good balance between providing high initial capacity and maintaining higher cycle characteristics.

The Si alloy is unevenly distributed in the negative electrode active material layer in some cases. In this case, individual sections of Si alloy exhibit different potentials and different capacities. Accordingly, some of the sections of Si alloy within the negative electrode active material layer can react with Li ions excessively, and some sections of Si alloy cannot react with Li ions. The reaction of the Si alloy within the negative electrode active material layer with Li ions can therefore occur inhomogeneously. When the sections of Si alloy that can excessively react with Li ions among the aforementioned sections of Si alloy act excessively, the electrolyte can be decomposed by significant reaction with the electrolyte, or the structure of the Si alloy can be broken by excessive expansion. As a result, when the Si alloy has excellent characteristics but is distributed unevenly, the cycle characteristics could be degraded as the negative electrode for an electric device.

However, when the Si alloy is mixed with a carbon material, the aforementioned problem can be solved. To be specific, when being mixed with a carbon material, the Si alloy can be distributed uniformly within the negative electrode active material layer. Accordingly, every section of the Si alloy within the negative electrode active material layer exhibits equal reactive properties, so that the degradation of the cycle characteristics is prevented.

When the carbon material is mixed, the content of the Si alloy in the negative electrode active material layer is reduced, and the initial capacity can be therefore reduced. However, the carbon material itself is reactive to Li ions, and the reduction of the initial capacity is relatively small. In other words, the negative electrode active material according to the embodiment exhibits a higher effect on improving the cycle characteristics than the effect on reducing the initial capacity.

The carbon material is less likely to change in volume in the process of reacting with Li ions compared with the Si alloy. Accordingly, even when the Si alloy undergoes a large volume change, the volume change due to the reaction with Li has a relatively minor influence on the entire negative electrode active material. The aforementioned effect can be understood from the results of examples that the higher the content rate of the carbon material (the lower the content rate of the Si alloy), the higher the cycle characteristics (see Table 4 and Fig. 23).

The contained carbon material can improve the power consumption (Wh). To be specific, the carbon material has a relatively low potential compared with the Si alloy and can reduce the relatively high potential of the Si alloy. The potential of the entire negative electrode is therefore reduced, thus improving the power consumption (Wh). This effect is advantageous particularly in vehicle applications among electric devices, for example.

The shape of the carbon material is not particularly limited and can be spherical, elliptical, cylindrical, polygonal columnar, flaky, or amorphous.

The average particle diameter of the carbon material is not particularly limited but is preferably 5 to 25 µm and more preferably 5 to 10 µm. In regard to the comparison with the average particle diameter of the Si alloy, the average particle diameter of the Si alloy is smaller than that of the carbon material. When the average particle diameter of the carbon material is larger than that of the Si alloy, particles of the carbon material are distributed homogeneously, and the Si alloy is located between the particles of the carbon material. Accordingly, the Si alloy can be therefore homogeneously located within the negative electrode active material layer.

The ratio in average particle diameter of the carbon material to the Si alloy (the average particle diameter of the Si alloy / the average particle diameter of the carbon material) is preferably not less than 1/250 and less than 1 and more preferably not less than 1/100 and not more than 1/4.

The mixing proportions of the Si alloy and the carbon material in the negative electrode active material are not particularly limited and can be properly selected in accordance with the desired intended use or the like. The content rate of the Si alloy in the negative electrode active material is preferably 3 to 70 mass%. In an embodiment, the content rate of the Si alloy in the negative electrode active material is more preferably 30 to 50 mass%. In another embodiment, the content rate of the Si alloy in the negative electrode active material is more preferably 50 to 70 mass%.

The battery can have high initial capacity when the content rate of the Si alloy is not less than 3 mass%, which is preferable. On the other hand, the battery can exhibit high cycle characteristics when the content rate of the Si alloy is not more than 70 mass%, which is preferable.

### Method of Manufacturing Negative electrode active material

The negative electrode active material can be manufactured by a publicly-known method without any particular restriction. Typically, the negative electrode active material layer is formed by the aforementioned manufacturing methods of the Si alloy. To be specific, the Si alloy is produced in the form of particles by using mechanical alloying method, arc plasma melting method, or the like and is then mixed with the carbon material, binder, electrically-conductive auxiliary agent, and viscosity modifying solvent to form slurry. The slurry is used to form slurry electrodes. In this process, the negative electrode active material with a desired content of the Si alloy can be manufactured by properly changing the amount of the Si alloy in the form of particles and the amount of the carbon material.

### (Common Requirements for Positive and negative electrode active material layers 13 and 15)

Hereinafter, a description is given of common requirements for the positive and negative electrode active material layers 13 and 15.

The positive and negative electrode active material layers 13 and 15 contain a binder, an electrically-conductive auxiliary agent, an electrolyte salt (lithium salt), an ion conducting polymer, and the like.

### Binder

The binder used in the active material layers is not particularly limited, and examples thereof can be the following materials: thermoplastic polymers such as polyethylene, polypropylene, polyethylene terephthalate (PET), polyethernitrile (PEN), polyacrylonitrile, polyimide, polyamide, polyamide-imide, cellulose, carboxymethyl cellulose (CMC), ethylene-vinyl acetate copolymer, polyvinylchloride, styrene-butadiene rubber (SBR), isoprene rubber, butadiene rubber, ethylene-propylene rubber, ethylene-propylene-diene copolymer, styrene-butadiene-styrene block copolymer and hydrogenated product thereof, and styrene-isoprene-styrene block copolymer and hydrogenated product thereof; fluorine resin such as polyvinylidene fluoride (PVdF), polytetrafluoroethylene (PTFE), tetrafluoroethylene-hexafluoropropylene copolymer (FEP), tetrafluoroethylene-perfluoroalkylvinyl ether copolymer (PFA), ethylene-tetrafluoroethylene copolymer (ETFE), polychlorotrifluoroethylene (PCTFE), ethylene-chlorotrifluoroethylene copolymer (ECTFE), and polyvinyl fluoride (PVF); vinylidene fluoride based fluorine rubber such as vinylidene fluoride-hexafluoropropylene based fluorine rubber (VDF-HFP based fluorine rubber), vinylidene fluoride-hexafluoropropylene-tetrafluoroethylene based fluorine rubber (VDF-HFP-TFE based fluorine rubber), vinylidene fluoride-pentafluoropropylene based fluorine rubber (VDF-PFP based fluorine rubber), vinylidene fluoride-pentafluoropropylene-tetrafluoroethylene based fluorine rubber (VDF-PFP-TFE based fluorine rubber), vinylidene fluoride-perfluoromethylvinylether-tetrafluoroethylene based fluorine rubber (VDF-PFMVE-TFE based fluorine rubber), vinylidene fluoride-chlorotrifluoroethylene based fluorine rubber (VDF-CTFE based fluorine rubber); epoxy resin; or the like. Among the aforementioned substances, polyvinylidene fluoride, polyimide, styrene-butadiene rubber, carboxymethylcellulose, polypropylene, polytetrafluoroethylene, polyacrylonitrile, polyamide, and polyamide-imide are more preferable, and polyamide is still more preferable. These preferable materials as the binder are excellent in heat resistance and have a very wide potential window. The above preferable materials as the binder are therefore stable at both of the positive electrode and negative electrode potentials and can be used in the active material layers. Moreover, the materials having relatively high binding force, such as polyamide, can suitably hold the Si alloy on the carbon material. The binder can be composed of only one or a combination of two of the aforementioned materials as the binder.

The amounts of binder contained in the active material layers are not particularly limited but need to be large enough to bind the active materials. The content of binder in the active material layers is preferably 0.5 to 15 mass% and more preferably 1 to 10 mass%.

### Electrically-Conductive Auxiliary Agent

The electrically-conductive auxiliary agent is an additive blended to improve the electrical conductivity of the positive or negative electrode active material layers. The electrically-conductive auxiliary agent can be a carbon material, including carbon black such as acetylene black, graphite, and vapor-grown carbon fibers. When the active material layers contain the electrically-conductive auxiliary agent, electron networks are effectively formed within the active material layers, thus contributing an improvement in output characteristics of the battery.

Alternatively, an electrically-conductive binder functioning as both of the electrically-conductive auxiliary agent and binder may be replaced for the electrically-conductive auxiliary agent and binder or may be used together with one or both of the electrically-conductive auxiliary agent and binder. The electrically-conductive binder can be TAB-2 (manufactured by Hohusen Corp.), which is already commercially available.

The content of the electrically-conductive auxiliary agent mixed into each active material layer is not less than 1 mass% of the total amount of the active material layer, preferably not less than 3 mass%, and more preferably not less than 5 mass%. The content of the electrically-conductive auxiliary agent mixed into each active material layer is not more than 15 mass% of the total amount of the active material layer, preferably not more than 10 mass%, and more preferably not more than 7 mass%. When the mixing ratio (the content) of the electrically-conductive auxiliary agent in each active material layer, in which the active material itself has low electron conductivity and electrode resistance can be reduced in accordance with the amount of the electrically-conductive auxiliary agent, is set in the aforementioned range, the following effect is exerted. It is possible to guarantee sufficient electron conductivity without inhibiting the electrode reaction and prevent reduction of energy density due to reduction of electrode density. Accordingly, the energy density can be increased by an increase in electrode density.

### Electrolyte Salt (lithium salt)

The electrolyte salt (lithium salt) can be Li(C₂F₅SO₂)₂N, LiPF₆, LiBF₄, LiClO₄, LiAsF₆, LiCF₃SO₃, or the like.

### Ion Conducting Polymer

The ion conducting polymer can be polyethylene oxide (PEO)-based or polypropylene oxide (PPO)-based polymer, for example.

The mixing ratios of the components contained in the positive electrode active material layer and contained in the negative electrode active material layer employing the Si alloy in the form of particles of (5)(ii) shown above are not particularly limited. The mixing ratios can be adjusted by properly referring to publicly-known findings about non-aqueous secondary batteries.

The thickness of each active material layer (the active material layer on one side of each current collector) is not particularly limited and can be determined by properly referring to conventionally-known findings about batteries. In view of the intended use (such as output power-desirable or energy-desirable applications) and the ion conductivity, as an example, the thickness of each active material layer is set to typically about 1 to 500 µm and preferably set to 2 to 100 µm.

### <Current Collector>

The current collectors 11 and 12 are composed of electrically-conductive materials. The size of the current collectors is determined in accordance with the intended use of the battery. The current collectors have large area when the current collectors are used in large batteries required to have high energy density, for example.

The thickness of the current collectors is also not limited particularly. The thickness of the current collectors is typically about 1 to 100 µm.

The shape of the current collectors is also not limited particularly. In the laminated battery 10 illustrated in Fig. 1, the shape of the current collectors can be mesh (expanded grid or the like) or the like as well as current collecting foil.

When alloy thin film of the negative electrode active material is directly formed on each negative electrode current collector 12 by sputtering or the like, the current collectors are desirably composed of current collecting foil.

The materials constituting the current collectors are not particularly limited. The current collectors can be made of metal or resin which is composed of an electrically-conductive polymer material or composed of a non-electrically-conductive polymer material with an electrically-conductive filler added thereto, for example.

To be specific, the metal of the current collectors can be aluminum, nickel, iron, stainless, titanium, copper, or the like. In addition to these materials, metal clad of nickel and aluminum, metal clad of copper and aluminum, plated materials of the same combinations, and the like are preferably used. Alternatively, the current collectors may be composed of foil with the metal surface thereof coated with aluminum. Among these materials, aluminum, stainless, copper, and nickel are preferable from the viewpoint of electron conductivity, battery operating potential, adherence of the negative electrode active material to the current collectors by sputtering, and the like.

Examples of the electrically-conductive polymer material include polyaniline, polypyrrole, polythiophene, polyacetylene, polyparaphenylene, polyphenylenevinylene, polyacrylonitrile, and polyoxadiazole. These electrically-conductive polymer materials exhibit sufficient conductivity with no electrically-conductive filler added thereto and therefore have advantages of simplifying the manufacturing process and reducing the weight of the current collectors.

Examples of the non-electrically-conductive polymer material include polyethylene (PE: high-density polyethylene (HDPE), low-density polyethylene (LDPE), and the like), polypropylene (PP), polyethylene terephthalate (PET), polyethernitrile (PEN), polyimide (PI), polyamide-imide (PAI), polyamide (PA), polytetrafluoroethylene (PTFE), styrene-butadiene rubber (SBR), polyacrylonitrile (PAN), polymethylacrylate (PMA), polymethylmethacrylate (PMMA), polyvinylchloride (PVC), polyvinylidene fluoride (PVdF), and polystyrene (PS). These non-electrically-conductive polymer materials can be excellent in resistance to electric potential or resistance to solvent.

To the aforementioned electrically-conductive and non-electrically-conductive polymer materials, an electrically-conductive filler can be added if necessary. When the resin constituting the base material of the current collectors is composed of only a non-electrically-conductive polymer in particular, an electrically-conductive filler needs to be added to give conductivity to the resin.

The electrically-conductive filler can be used without any particular restriction but needs to be an electrically-conductive substance. For example, the electrically-conductive filler can be metal, electrically-conductive carbon, or the like as materials excellent in conductivity, potential resistance, or lithium ion blocking properties, for example. The metal as the electrically-conductive filler is not particularly limited but is preferably at least a kind of metal selected from the group consisting of Ni, Ti, Al, Cu, Pt, Fe, Cr, Sn, Zn, In, Sb, K, and alloys and metal oxides including the same. The electrically-conductive carbon as the electrically-conductive filler is not particularly limited and preferably contains at least a kind of carbon selected from the group consisting of acetylene black, Vulcan, black pearl, carbon nanofibers, Ketjenblack, carbon nanotubes, carbon nanohones, carbon nanoballoons, and fullerene.

The amount of electrically-conductive filler added is not particularly limited but needs to be large enough to give sufficient conductivity to the current collectors, which is generally about 5 to 35 mass%.

### <Electrolyte Layer>

The electrolyte constituting the electrolyte layer 17 can be a liquid or polymer electrolyte.

The liquid electrolyte has a configuration in which a lithium salt (an electrolyte salt) is dissolved in an organic solvent. Examples of the organic solvent include carbonates such as ethylene carbonate (EC), propylene carbonate (PC), butylene carbonate (BC), vinylene carbonate (VC), dimethyl carbonate (DMC), diethyl carbonate (DEC), ethylmethyl carbonate (EMC), or methylpropyl carbonate (MPC).

The lithium salt can be a compound that can be added to the active material layers of the electrodes such as Li(CF₃SO₂)₂N, Li(C₂F₅SO₂)₂N, LiPF₆, LiBF₄, LiAsF₆, LiTaF₆, LiClO₄, or LiCF₃SO₃.

On the other hand, the polymer electrolytes are classified to gel electrolytes including electrolytic solution and intrinsic polymer electrolytes not including electrolytic solution.

The gel electrolytes have a configuration in which the aforementioned liquid electrolyte (electrolytic solution) is injected into a matrix polymer composed of ion-conductive polymer. Using a gel polymer electrolyte as the electrolyte is excellent because the lack of fluidity of the electrolyte can facilitate blocking ion conduction between layers.

The ion conductive polymer used as the matrix polymer is polyethylene oxide (PEO), polypropylene oxide (PPO), copolymers thereof, or the like, for example. In the above polyalkylene oxide, electrolyte salt such as lithium salt is well soluble.

The proportion of the aforementioned liquid electrolyte (electrolytic solution) in the gel electrolyte should not be particularly limited but is desirably about several to 90 mass% from the viewpoint of ion conductivity and the like. In the embodiment, the gel electrolyte containing a lot of electrolytic solution (the proportion thereof is not less than 70 mass%) is particularly effective.

When the electrolyte layer is composed of liquid electrolyte, gel electrolyte, or intrinsic polymer electrolyte, the electrolyte layer may include a separator. Examples of the specific configuration of the separator (including non-woven fabric) are microporous membrane composed of olefin, such as polyethylene and polypropylene, porous plates, non-woven fabric, and the like.

Intrinsic polymer electrolytes have a configuration in which supporting salt (lithium salt) is dissolved in the matrix polymer and does not contain any organic solvent as a plasticizer. Accordingly, when the electrolyte layers are composed of an intrinsic polymer electrolyte, there is no fear of liquid leakage from the battery, thus increasing the reliability of the battery.

The matrix polymer of gel electrolytes or intrinsic polymer electrolytes can exert excellent mechanical strength by forming a cross-linked structure. To form a cross-linked structure, by using an adequate polymerization initiator, a polymerizable polymer (PEO or PPO, for example) for forming polymer electrolyte is subjected to polymerization such as thermal polymerization, ultraviolet polymerization, radiation polymerization, or electron beam polymerization.

### <Current Collecting Plate and Lead>

Current collecting plates may be used for the purpose of extracting current out of the battery. The current collecting plates are electrically connected to the current collectors and leads and protrude out of the laminated sheets as the battery exterior member.

The materials constituting the current collecting plates are not particularly limited and can be publicly-known highly-electrically-conductive material conventionally used as current collecting plates for lithium ion secondary batteries. The material constituting the current collecting plates is preferably a metallic material such as aluminum, copper, titanium, nickel, stainless steel (SUS), or alloys thereof and is more preferably, aluminum, copper, or the like from the viewpoint of light weight, corrosion resistance, and high conductivity. The positive and negative electrode current collecting plates may be made of a same material or different materials.

The positive and negative electrode terminal leads are also used when needed. The positive and negative electrode terminal leads can be composed of terminal leads used in publicly-known lithium ion secondary batteries. It is preferable that the parts of the terminal leads protruding out of the battery exterior member 29 are covered with heat-resistant insulating heat-shrinkable tubes so that electric leakage due to contact with peripheral devices and wires cannot influence products (for example, automobile components, particularly, electronic devices).

### <Battery Exterior Member>

The battery exterior member 29 can be composed of a publicly-known metallic can casing or a bag-shaped casing which can cover the power generation element and is made of aluminum-contained laminated film. The laminated film can be a three-layer laminated film composed of PP, aluminum, and nylon stacked in this order, for example, but is not limited to the thus-configured film. The battery exterior member 29 is preferably made of laminated film for the laminated film is excellent in resistance to high output power and cooling performance and can be suitably used in batteries of large devices for EVs, HEVs, and the like.

The above-described lithium ion secondary battery can be manufactured by a conventionally-known manufacturing method.

### <Exterior Configuration of Lithium Ion Secondary Battery>

Fig. 2 is a perspective view illustrating an exterior of a laminate-type flat lithium ion secondary battery.

As illustrated in Fig. 2, a laminate-type flat lithium ion secondary battery 50 has a rectangular flat shape. From both sides of the battery 50, positive and negative electrode current collecting plates 58 and 59 for extracting electric power are protruded. A power generation element 57 is wrapped with a battery exterior member 52 of the lithium ion secondary battery 50, and the edge thereof is thermally fused. The power generation element 57 is sealed with the positive and negative electrode current collecting plates 58 and 59 protruded to the outside. Herein, the power generation element 57 corresponds to the power generation element 21 of the lithium ion secondary battery (laminated battery) 10 illustrated in Fig. 1. The power generation element 57 includes plural single cell layers (single cells) 19, each of which includes a positive electrode (a positive electrode active material layer) 13, an electrolyte layer 17, and a negative electrode (a negative electrode active material layer) 15.

The aforementioned lithium ion secondary battery is not limited to batteries having a laminate-type flat shape (laminate cells). The winding-type lithium batteries are not particularly limited and may include batteries having a cylindrical shape (coin cells), batteries having a prism shape (rectangular cells), batteries having a rectangular flat shape like deformed cylindrical batteries, and also cylinder cells. In cylindrical or prism-shaped lithium ion secondary batteries, the package may be composed of either laminated film or a conventional cylindrical can (metallic can) and is not limited particularly. Preferably, the power generation element is packed with aluminum laminated film. Such configuration can reduce the weight of the lithium ion secondary battery.

The protrusion configuration of the positive and negative electrode current collecting plates 58 and 59 illustrated in Fig. 2 is also not limited particularly. The positive and negative electrode current collecting plates 58 and 59 may be protruded from a same side or may be individually divided into plural portions to be protruded from different sides. The protrusion of the positive and negative electrode current collecting plates 58 and 59 is not limited to the configuration illustrated in Fig. 2. Moreover, in winding-type lithium ion batteries, terminals may be formed using a cylindrical can (a metallic can), for example, instead of the current collecting plates.

As described above, negative electrodes and lithium ion secondary batteries employing the negative electrode active material for a lithium ion secondary battery of the embodiment can be suitably used as high-capacity power supplies of electric vehicles, hybrid electric vehicles, fuel cell vehicles, hybrid fuel cell vehicles, and the like. The negative electrodes and lithium ion secondary batteries employing the negative electrode active material for a lithium ion secondary battery of the embodiment can be thus suitably used in vehicle driving power supply and auxiliary power supply requiring high energy density per volume and high power density per volume.

The aforementioned embodiment shows the lithium ion batteries as the electric device by way of example but is not limited thereto. The embodiment is applicable to another type of secondary batteries and is also applicable to primary batteries. Moreover, the embodiment is applicable to capacitors as well as batteries.

### EXAMPLES

The present invention is described in more detail using examples below. The technical scope of the invention is not limited to the examples shown below.

First, as reference examples, Si alloy which is expressed by chemical formula (1) and constitutes the negative electrode for an electric device according to the present invention is subjected to performance evaluation.

### (Reference examples A): Performance evaluation of SiₓZn_{y}V_{z}Aₐ - not falling under the scope of the present invention

### [1] Preparation of Negative electrode

As a sputtering apparatus, an independently controllable ternary DC magnetron sputtering apparatus (manufactured by Yamato-Kiki Industrial Co., Ltd.; combinatorial sputter coating apparatus; gun-sample distance: approximately 100 mm) was used. By using this apparatus, a thin film of the negative electrode active material alloy having each composition was deposited on a substrate (current collector) made of a 20 µm-thick nickel foil, with the target and film preparation conditions stated below. As a result, 31 types of negative electrode samples were obtained in total, which have thin films of the negative electrode active material alloy having compositions shown in Table 1 (reference examples 1-9 and comparative reference examples 1-27).

### (1) Target (manufactured by Kojundo Chemical Lab. Co., Ltd., purity: 4N)

Si: 50.8 mm diameter, 3 mm thick (with a 2 mm-thick oxygen-free copper backing plate)
Zn: diameter of 50.8 mm, thickness of 5 mm
V: diameter of 50.8 mm, thickness of 5 mm

### (2) Film Formation Condition

Base pressure: to 7×10⁻⁶ Pa
Sputtering gas species: Ar (99.9999% or more)
Flow rate of introduced sputtering gas: 10 sccm
Sputtering pressure: 30 mTorr
DC power supply: Si (185 W), Zn (0 to 50 W), V (0 to 150 W)
Pre-sputtering time: 1 min.
Sputtering time: 10 min.
Substrate Temperature: Room Temperature (25°C)

In other words, by using the foregoing Si target, Zn target, and V target, sputtering time was fixed to 10 minutes, and power of the DC power supply was changed in the above-stated range, respectively. In this way, alloy thin films in an amorphous state were deposited on the Ni substrates, and negative electrode samples having alloy thin films with various compositions were obtained.

Several examples of sample preparation conditions are shown here. In Sample No. 22 (reference example), DC power supply 1 (Si target) is set to 185 W, DC power supply 2 (Zn target) is set to 40 W, and DC power supply 3 (V target) is set to 75 W. In Sample No. 30 (comparative reference example), DC power supply 1 (Si target) is set to 185 W, DC power supply 2 (Zn target) is set to 0 W, and DC power supply 3 (V target) is set to 80 W. Further, in Sample No. 35 (comparative reference example), DC power supply 1 (Si target) is set to 185 W, DC power supply 2 (Zn target) is set to 42 W, and DC power supply 3 (V target) is set to 0 W.

Component compositions of these alloy thin films are shown in Table 1 and Fig. 3. The alloy thin films obtained are analyzed by the following analysis process and the apparatus.

### (3) Analytical method

Composition Analysis: SEM·EDX analysis (manufactured by JEOL Ltd.), EPMA analysis (manufactured by JEOL Ltd.)
Film thickness measurement (for calculating sputtering rate): film thickness meter (manufactured by Tokyo Instruments, Inc.)
Film state analysis: Raman spectrometry (manufactured by Bruker Corporation)

### [2] Preparation of Battery

After each of the negative electrode samples obtained as above and a counter electrode (a positive electrode) made of a lithium foil are faced each other through a separator, an electrolytic solution was injected, and a CR2032 coin cell prescribed by IEC60086 was thus fabricated.

A lithium foil manufactured by Honjo Metal Co., Ltd was used as a lithium foil of the counter electrode, which was punched out to have a diameter of 15 mm and a thickness of 200 µm. Celgard 2400 manufactured by Celgard, LLC. was used as the separator. As the electrolytic solution, an electrolytic solution was used, which was obtained by dissolving LiPF₆ (lithium hexafluorophosphate) to have a concentration of 1M in a mixed nonaqueous solvent made by mixing ethylene carbonate (EC) and diethyl carbonate (DEC) with a volume ratio of 1 : 1. The counter electrode can be a positive electrode slurry electrode (for example, LiCoO₂, LiNiO₂, LiMn₂O₄, Li(Ni, Mn, Co)O₂, Li(Li, Ni, Mn, Co)O₂, LiRO₂-LiMn₂O₄ (R = transition metal element of Ni, Mn, Co and the like).

### [3] Battery charge-discharge test

The following charge-discharge test was carried out on the respective batteries obtained as stated above.

In other words, by using a charge-discharge tester, charging and discharging were performed in a thermostat bath that was set to a temperature of 300K (27 °C). As the charge-discharge tester, HJ0501SM8A manufactured by HOKUTO DENKO Corp. was used, and, as the thermostat bath, PFU-3K manufactured by ESPEC Corp. was used.

Then, a charge process, or a process of inserting Li into a negative electrode to be evaluated, charging was performed from 2V to 10 mV with 0.1 mA in constant-current and constant-voltage mode. Thereafter, as a discharge process, or a process of separating Li from the above-mentioned negative electrode, discharging was performed from 10 mV to 2V with 0.1 mA in a constant current mode. The above-mentioned charge-discharge cycle was regarded as 1 cycle and was repeated for 50 times.

Then, discharge capacity was obtained in the 1st cycle and the 50th cycle. The results are shown in Table 1 as well. "Discharge capacity retention rate (%) in the 50th cycle" in Table 1 indicates a rate of discharge capacity in the 50th cycle to discharge capacity in the 1st cycle ((discharge capacity in the 50th cycle) / (discharge capacity in the 1st cycle) × 100). Also, charge-discharge capacity shows a value calculated per weight of an alloy.

In this specification, "discharge capacity (mAh/g)" is per weight of pure Si or an alloy, and shows capacity when Li reacts to a Si-Zn-M (M = V, Sn, Al, C) alloy (a Si-M alloy, pure Si, or a Si-Zn-Alloy). In this specification, the reference to the "initial capacity" corresponds to the "discharge capacity (mAh/g)" in the initial cycle (the 1st cycle).

**[Table 1]**

| No. | Composition (mass%) | | | 1st cycle | 50th cycle | | Classification |
|---|---|---|---|---|---|---|---|
| | Si | Zn | V | Discharge capacity (mAh/g) | Discharge capacity (mAh/g) | Discharge capacity retention rate (%) | |
| 1 | 41 | 8 | 51 | 1075 | 986 | 89 | Reference example A1 |
| 2 | 31 | 5 | 64 | 697 | 648 | 90 | Comparative reference example A1 |
| 3 | 59 | 20 | 21 | 1662 | 1378 | 82 | Comparative reference example A2 |
| 4 | 39 | 13 | 48 | 1019 | 962 | 91 | Reference example A2 |
| 5 | 29 | 10 | 61 | 676 | 658 | 93 | Comparative reference example A3 |
| 6 | 54 | 27 | 19 | 1467 | 1311 | 87 | Comparative reference example A4 |
| 7 | 37 | 18 | 45 | 989 | 952 | 93 | Reference example A3 |
| 8 | 28 | 14 | 59 | 687 | 691 | 95 | Comparative reference example A5 |
| 9 | 49 | 33 | 18 | 1405 | 1252 | 87 | Comparative reference example A6 |
| 10 | 34 | 23 | 43 | 912 | 885 | 93 | Reference example A4 |
| 11 | 27 | 17 | 56 | 632 | 653 | 96 | Comparative reference example A7 |
| 12 | 46 | 37 | 17 | 1261 | 1112 | 84 | Comparative reference example A8 |
| 13 | 33 | 27 | 40 | 862 | 836 | 93 | Reference example A5 |
| 14 | 51 | 9 | 40 | 1413 | 1178 | 81 | Comparative reference example A9 |
| 15 | 35 | 6 | 59 | 841 | 815 | 93 | Reference example A6 |
| 16 | 27 | 5 | 68 | 570 | 542 | 90 | Comparative reference example A10 |
| 17 | 47 | 16 | 37 | 1245 | 1148 | 90 | Reference example A7 |
| 18 | 33 | 11 | 56 | 821 | 782 | 93 | Reference example A8 |
| 19 | 26 | 9 | 65 | 532 | 541 | 95 | Comparative reference example A11 |
| 20 | 31 | 16 | 53 | 746 | 765 | 94 | Comparative reference example A12 |
| 21 | 25 | 12 | 63 | 566 | 576 | 94 | Comparative reference example A13 |
| 22 | 41 | 27 | 32 | 1079 | 1045 | 93 | Reference example A9 |
| 23 | 30 | 20 | 50 | 699 | 718 | 94 | Comparative reference example A14 |
| 24 | 24 | 16 | 60 | 530 | 567 | 97 | Comparative reference example A15 |
| 25 | 22 | 22 | 56 | 481 | 492 | 93 | Comparative reference example A16 |
| 26 | 100 | 0 | 0 | 3232 | 1529 | 47 | Comparative reference example A17 |
| 27 | 65 | 0 | 35 | 1451 | 1241 | 85 | Comparative reference example A18 |
| 28 | 53 | 0 | 47 | 1182 | 1005 | 85 | Comparative reference example A19 |
| 29 | 45 | 0 | 55 | 986 | 824 | 83 | Comparative reference example A20 |
| 30 | 34 | 0 | 66 | 645 | 589 | 90 | Comparative reference example A21 |
| 31 | 30 | 0 | 70 | 564 | 510 | 88 | Comparative reference example A22 |
| 32 | 27 | 0 | 73 | 459 | 422 | 86 | Comparative reference example A23 |
| 33 | 25 | 0 | 75 | 366 | 345 | 86 | Comparative reference example A24 |
| 34 | 75 | 25 | 0 | 2294 | 1742 | 76 | Comparative reference example A25 |
| 35 | 58 | 42 | 0 | 1625 | 1142 | 70 | Comparative reference example A26 |
| 36 | 47 | 53 | 0 | 1302 | 961 | 74 | Comparative reference example A27 |

In Table 1, Examples 1 to 36 do not fall under the scope of the present invention.

According to the above results, it was confirmed that, a battery, which used a Si-Zn-V-based alloy having each component within a specific range as a negative electrode active material, had excellent balance between initial capacity and cycle characteristics. In particular, it was confirmed that a battery that used a Si-Zn-V-based alloy as a negative electrode active material, with an alloy composition where x is 33-50, y is more than 0 and is not more than 46, and z is in a range of 21-67, had particularly excellent balance between initial capacity and cycle characteristics. To be in more detail, it was found that batteries No. 1, 4, 7, 10, 13, 15, 17, 18 and 22 (reference examples A1-A9), which correspond to the battery using a Si alloy negative electrode active material having the composition in the above-mentioned range, showed initial capacity over 800 mAh/g and a discharge capacity retention rate of 89% or higher. According to this, it was confirmed that the batteries of reference examples A1-A9 had especially excellent balance between initial capacity and cycle characteristics.

### (Reference examples B): Performance evaluation of SiₓZn_{y}Sn_{z}Aₐ

### [1] Preparation of negative electrodes

For the target stated in (1) in reference examples A, "Zn: diameter of 50.8 mm, thickness of 5 mm" was changed to "Zn: diameter of 50.8 mm, thickness of 3 mm", and "V: diameter of 50.8 mm, thickness of 5 mm" was changed to "Sn: diameter of 50.8 mm, thickness of 5 mm". Further, for DC power supply in (2), "Zn (0-50 W), V (0-150 W)" was changed to "Zn (0-150 W), Sn (0-40 W)". Apart from these changes, a similar way to reference examples A was used to fabricate 44 types of negative electrode samples in total (reference examples B1-B32 and comparative reference examples B1-B14).

In short, the Si target, Zn target, and Sn target stated above were used, sputtering time was fixed to 10 minutes, and then power of DC power supply was changed within the above-mentioned range. In this way, alloy thin films in an amorphous state were deposited on Ni substrates, and negative electrode samples having alloy thin films with various compositions were obtained.

As some examples of sample preparation conditions regarding the DC power supply in (2) above, for reference example B4, DC power supply 1 (Si target) is set to 185 W, DC power supply 2 (Sn target) is set to 22 W, and DC power supply 3 (Zn target) is set to 100 W. Further, in comparative reference example B2, DC power supply 1 (Si target) is set to 185 W, DC power supply 2 (Sn target) is set to 30 W, and DC power supply 3 (Zn target) is set to 0 W. Furthermore, in comparative reference example B5, DC power supply 1 (Si target) is set to 185 W, DC power supply 2 (Sn target) is set to 0 W, and DC power supply 3 (Zn target) is set to 25 W.

These component compositions of alloy thin films are shown in Table 2-1, Table 2-2. Analysis of the alloy thin films obtained was carried out by the analysis process and the apparatus similar to those for reference examples A.

### [2] Preparation of batteries

CR2032 coin cells were fabricated in a similar way to those in reference examples A.

### [3] Battery charge-discharge test

Charge-discharge test of a battery was conducted in a similar way to that in reference examples A. However, while the charge-discharge cycle was repeated for 50 times in reference examples A, the charge-discharge cycle was repeated for 100 times in reference examples B.

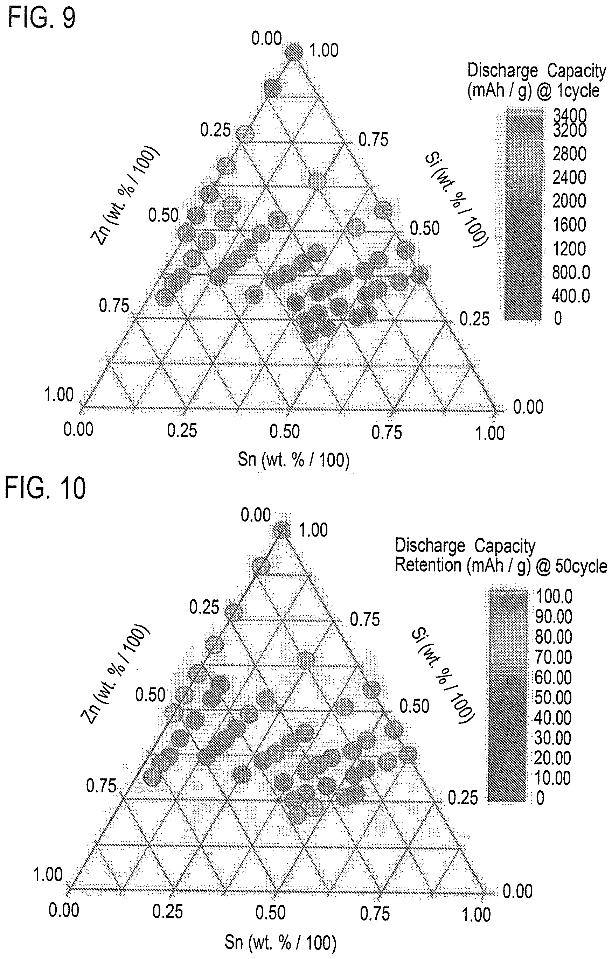

Then, discharge capacity was obtained in the 1st cycle, the 50th cycle, and the 100th cycle. A discharge capacity retention rate (%) in the 50th cycle and 100th cycle with respect to discharge capacity in the 1st cycle was calculated, respectively. Both of the results are shown in Table 2-1 and Table 2-2, and also shown in Fig. 9-Fig. 11. With regard to the discharge capacity retention rate (%) in the 50th cycle and the 100th cycle in Table 2-1 and Table 2-2, for example, a discharge capacity retention rate (%) in the 50th cycle was calculated as ((discharge capacity in the 50th cycle) / (discharge capacity in the 1st cycle)) × 100.

**[Table 2-1]**

| Reference examples B | Composition (mass%) | | | Discharge capacity in the 1st cycle (mAh/g) | Discharge capacity retention rate (%) | |
|---|---|---|---|---|---|---|
| | Si | Sn | Zn | | 50th cycle | 100th cycle |
| 1 | 57 | 7 | 36 | 2457 | 94 | 69 |
| 2 | 53 | 7 | 40 | 2357 | 100 | 89 |
| 3 | 47 | 6 | 47 | 2200 | 100 | 98 |
| 4 | 42 | 5 | 53 | 2121 | 100 | 100 |
| 5 | 37 | 5 | 58 | 1857 | 96 | 93 |
| 6 | 35 | 4 | 61 | 1813 | 93 | 61 |
| 7 | 53 | 20 | 27 | 2022 | 92 | 64 |
| 8 | 49 | 18 | 33 | 1897 | 93 | 72 |
| 9 | 45 | 17 | 38 | 1712 | 94 | 72 |
| 10 | 42 | 16 | 42 | 1659 | 100 | 80 |
| 11 | 40 | 15 | 45 | 1522 | 100 | 84 |
| 12 | 37 | 14 | 49 | 1473 | 100 | 92 |
| 13 | 51 | 40 | 9 | 2031 | 92 | 53 |
| 14 | 44 | 34 | 22 | 1803 | 92 | 58 |
| 15 | 41 | 32 | 27 | 1652 | 93 | 60 |
| 16 | 38 | 30 | 32 | 1547 | 94 | 70 |
| 17 | 36 | 28 | 36 | 1448 | 100 | 82 |
| 18 | 32 | 25 | 43 | 1253 | 100 | 84 |
| 19 | 42 | 50 | 8 | 1626 | 92 | 61 |
| 20 | 39 | 48 | 13 | 1603 | 92 | 65 |
| 21 | 37 | 44 | 19 | 1501 | 92 | 68 |
| 22 | 35 | 42 | 23 | 1431 | 93 | 69 |
| 23 | 33 | 40 | 27 | 1325 | 92 | 70 |
| 24 | 30 | 36 | 34 | 1248 | 100 | 83 |
| 25 | 36 | 58 | 6 | 1522 | 92 | 58 |
| 26 | 34 | 54 | 12 | 1453 | 95 | 67 |
| 27 | 32 | 52 | 16 | 1362 | 96 | 72 |
| 28 | 29 | 47 | 24 | 1249 | 76 | 74 |
| 29 | 27 | 43 | 30 | 1149 | 94 | 82 |
| 30 | 25 | 41 | 34 | 1094 | 93 | 87 |
| 31 | 27 | 55 | 18 | 1191 | 92 | 78 |
| 32 | 26 | 53 | 21 | 1142 | 92 | 77 |

In Table 2-1, Example 13 does not fall under the scope of the present invention.

**[Table 2-2]**

| Comparative reference examples B | Composition (mass%) | | | Discharge capacity rate in the 1 st cycle (mAh/g) | Discharge capacity retention rate (%) | |
|---|---|---|---|---|---|---|
| | Si | Sn | Zn | | 50th cycle | 100th cycle |
| 1 | 100 | 0 | 0 | 3232 | 47 | 22 |
| 2 | 56 | 44 | 0 | 1817 | 91 | 42 |
| 3 | 45 | 55 | 0 | 1492 | 91 | 42 |
| 4 | 38 | 62 | 0 | 1325 | 91 | 42 |
| 5 | 90 | 0 | 10 | 3218 | 82 | 36 |
| 6 | 77 | 0 | 23 | 2685 | 82 | 39 |
| 7 | 68 | 0 | 32 | 2398 | 82 | 39 |
| 8 | 60 | 0 | 40 | 2041 | 83 | 37 |
| 9 | 54 | 0 | 46 | 1784 | 83 | 32 |
| 10 | 49 | 0 | 51 | 1703 | 75 | 24 |
| 11 | 31 | 4 | 65 | 1603 | 91 | 40 |
| 12 | 64 | 24 | 12 | 2478 | 91 | 37 |
| 13 | 23 | 47 | 30 | 996 | 72 | 42 |
| 14 | 21 | 44 | 35 | 912 | 66 | 31 |

According to the results above, the batteries of reference examples B (see Table 2-1), which used a Si-Zn-Sn-based alloy as a negative electrode active material where each component was within a specific range or a range X shown in Fig. 5, had initial capacity that exceeds at least 1000 mAh/g as shown in Fig. 9. Then, as shown in Fig. 10 and Fig. 11, it was confirmed that the negative electrode active material made of a Si-Zn-Sn-based alloy within the range X in Fig. 5 shows a discharge capacity retention rate of 92% or higher after the 50th cycle, and over 50% even after the 100th cycle (see reference examples B1-B32 in Table 2-1).

### (Reference examples C): Performance evaluation of SiₓZn_{y}Al_{z}Aₐ - not falling under the scope of the present invention

### [1] Preparation of negative electrodes

For the target stated in (1) in reference examples A, "V (purity: 4N): diameter of 50.8 mm, thickness of 5 mm" was changed to "Al (purity: 5N): diameter of 50.8 mm (diameter of 2 inches), thickness of 5 mm". Further, for DC power supply in (2), "Zn (0-50 W), V (0-150 W)" was changed to "Zn (30-90 W), Al (30-180 W)". Apart from these changes, the similar way to reference examples A was used to fabricate 48 types of negative electrode samples (Samples 1-48 in reference examples C).

In short, the Si target, Zn target, and Al target stated above were used, sputtering time was fixed to 10 minutes, and then power of the DC power supply was changed within the above-mentioned range. In this way, alloy thin films in an amorphous state were deposited on Ni substrates, and negative electrode samples having alloy thin films with various compositions were obtained.

As some examples of sample preparation conditions regarding the DC power supply in (2) above, for Sample 6 of reference examples C, DC power supply 2 (Si target) is set to 185 W, DC power supply 1 (Zn target) is set to 70 W, and DC power supply 3 (Al target) is set to 50 W.

These component compositions of alloy thin films are shown in Table 3-1, Table 3-2. Analysis of the alloy thin films obtained was carried out by the analysis process and the apparatus similar to those for reference examples A.

### [2] Preparation of batteries

CR2032 coin cells were fabricated in a similar way to that in reference examples A.

### [3] Battery charge-discharge test

Charge-discharge test of a battery was conducted in a similar way to that in reference examples A.

In a long-term cycle, since cycle characteristics include a deterioration mode of an electrolytic solution (conversely, cycle characteristics get better when a high-performance electrolytic solution is used), data in the 50th cycle, in which component properties derived from an alloy are conspicuous, was used.

Then, discharge capacity was obtained in the 1st cycle and the 50th cycle. Also, discharge capacity retention rates (%) in the 50th cycle were calculated, respectively. Both results are shown in Table 3-1 and Table 3-2. Here, the "discharge capacity retention rate (%)" shows an index of "how much capacity is retained from the initial capacity". In short, a discharge capacity retention rate (%) in the 50th cycle was calculated as ((discharge capacity in the 50th cycle) / (maximum discharge capacity)) × 100. The maximum discharge capacity is shown between the initial cycle (the 1st cycle) and the 10th cycle, normally between the 5th and the 10th cycles.

**[Table 3-1]**

| Sample No. | Composition (mass%) | | | 1 st cycle | 50th cycle | |
|---|---|---|---|---|---|---|
| | Si | Zn | Al | Discharge capacity (mAh/g) | Discharge capacity (mAh/g) | Discharge capacity retention rate (%) |
| 1 | 73 | 25 | 2 | 2532 | 2252 | 89 |
| 2 | 60 | 20 | 20 | 2120 | 1898 | 90 |
| 3 | 50 | 17 | 32 | 1837 | 1654 | 90 |
| 4 | 43 | 56 | 1 | 1605 | 1372 | 85 |
| 5 | 38 | 49 | 13 | 1689 | 1523 | 90 |
| 6 | 30 | 69 | 1 | 1306 | 1162 | 89 |
| 7 | 28 | 63 | 9 | 1190 | 1079 | 91 |
| 8 | 26 | 58 | 16 | 1129 | 1054 | 93 |
| 9 | 44 | 15 | 41 | 1627 | 1517 | 93 |
| 10 | 39 | 13 | 48 | 1369 | 148 | 11 |
| 11 | 34 | 12 | 54 | 1268 | 71 | 6 |
| 12 | 31 | 40 | 29 | 1268 | 1223 | 96 |
| 13 | 28 | 37 | 35 | 1166 | 1104 | 95 |
| 14 | 26 | 34 | 40 | 1099 | 1055 | 96 |
| 15 | 24 | 54 | 22 | 896 | 616 | 69 |
| 16 | 22 | 50 | 28 | 824 | 297 | 36 |
| 17 | 21 | 47 | 32 | 871 | 306 | 35 |
| 18 | 34 | 44 | 22 | 1072 | 1016 | 95 |
| 19 | 78 | 19 | 2 | 2714 | 2414 | 89 |
| 20 | 53 | 13 | 34 | 1778 | 253 | 14 |
| 21 | 66 | 33 | 2 | 2458 | 2308 | 94 |
| 22 | 55 | 27 | 18 | 2436 | 2198 | 90 |
| 23 | 56 | 42 | 2 | 2432 | 2177 | 90 |
| 24 | 48 | 36 | 16 | 2065 | 1872 | 91 |
| 25 | 42 | 31 | 27 | 1910 | 1806 | 95 |
| 26 | 46 | 11 | 43 | 1695 | 221 | 13 |
| 27 | 40 | 10 | 50 | 1419 | 154 | 11 |
| 28 | 36 | 9 | 56 | 1309 | 74 | 6 |
| 29 | 36 | 18 | 46 | 1509 | 1430 | 95 |
| 30 | 33 | 16 | 51 | 1389 | 1298 | 93 |
| 31 | 37 | 28 | 35 | 1404 | 1262 | 90 |
| 32 | 33 | 25 | 42 | 1244 | 1150 | 92 |
| 33 | 30 | 23 | 47 | 1274 | 1179 | 93 |
| 34 | 47 | 23 | 30 | 1479 | 1401 | 95 |
| 35 | 41 | 20 | 39 | 1335 | 1290 | 97 |

In Table 3-1, Examples 1 to 35 do not fall under the scope of the present invention.

**[Table 3-2]**

| Sample No. | Composition (mass%) | | | 1 st cycle | 50th cycle | |
|---|---|---|---|---|---|---|
| | Si | Zn | Al | Discharge capacity (mAh/g) | Discharge capacity (mAh/g) | Discharge capacity retention rate (%) |
| 36 | 61 | 0 | 39 | 1747 | 1504 | 86 |
| 37 | 66 | 0 | 34 | 1901 | 1664 | 88 |
| 38 | 72 | 0 | 28 | 2119 | 1396 | 66 |
| 39 | 78 | 0 | 22 | 2471 | 1158 | 47 |
| 40 | 87 | 0 | 13 | 2805 | 797 | 28 |
| 41 | 97 | 0 | 3 | 3031 | 1046 | 35 |
| 42 | 100 | 0 | 0 | 3232 | 1529 | 47 |
| 43 | 90 | 10 | 0 | 3218 | 2628 | 82 |
| 44 | 77 | 23 | 0 | 2685 | 2199 | 82 |
| 45 | 68 | 32 | 0 | 2398 | 1963 | 82 |
| 46 | 60 | 40 | 0 | 2041 | 1694 | 83 |
| 47 | 54 | 46 | 0 | 1784 | 1485 | 83 |
| 48 | 49 | 51 | 0 | 1703 | 1272 | 75 |

In Table 3-2, Examples 36 to 48 do not fall under the scope of the present invention.

It was found that, in the batteries of Samples 1-35 in reference examples C, particularly in the samples with the composition ranges surrounded by the thick solid lines in Fig. 15-Fig. 17, it was possible to realize remarkably high capacity for discharge capacity in the 1st cycle, which is impossible to realize with the existing carbon-based negative electrode active material (a carbon and graphite-based negative electrode material). Similarly, it was also confirmed that it was possible to realize higher capacity (initial capacity of 1072 mAh/g or higher) than that of the existing Sn-based alloy negative electrode active material with high capacity. Further, with regard to cycle durability that is in a trade-off relation with high capacity, it was confirmed that remarkably excellent cycle durability could be realized compared to the existing Sn-based negative electrode active material and the multicomponent alloy negative electrode active material described in Patent Literature 1 that have high capacity but less cycle durability. To be specific, it was confirmed that remarkably excellent cycle durability could be realized with a high discharge capacity retention rate of 85% or higher, preferably 90% or higher, and especially preferably 95% or higher in the 50th cycle. According to this, among the batteries of Samples 1-35, the samples with the composition ranges surrounded by the thick solid lines in Fig. 15-Fig. 17 retained larger discharge capacity compared to those of the rest of the samples, which proved that a reduction in high initial capacity was suppressed and high capacity was maintained more efficiently (see Table 3-1).

From the results of reference examples C, it was found that it was extremely useful and effective to select the first additive element Zn, which suppresses amorphous-crystalline phase transition and improves cycle life at the time of Li alloying, and the second additive elemental species Al, which does not reduce capacity as an electrode when a concentration of the first additive element is increased. By selecting the first and second additive elements, it is possible to provide a Si alloy-based negative electrode active material having high capacity and high cycle durability. As a result, it was found that a lithium ion secondary battery having high capacity and good cycle durability could be provided. Further, with metal Si or a binary alloy in Samples 36-48 of reference examples C (see Table 3-2), it was not possible to obtain a battery having good balanced characteristics of both high capacity and high cycle durability, which are in a trade-off relation.

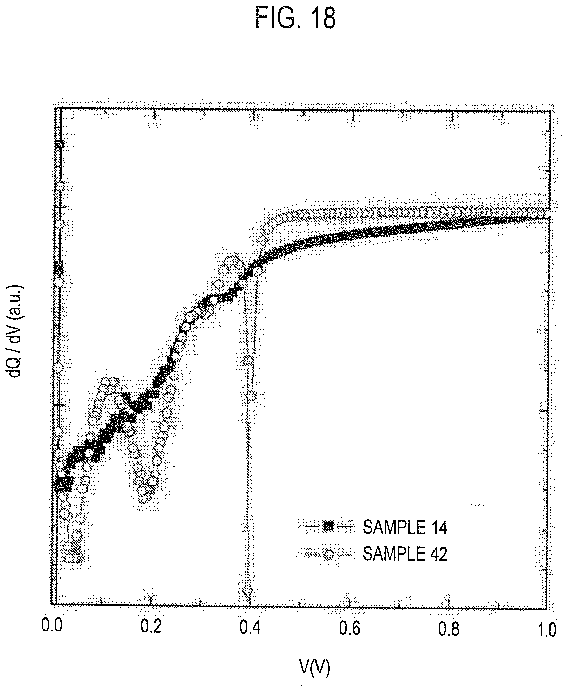

With the cells for evaluation (CR2032 coin cells) in which electrodes for evaluation of Samples 14, 42 of reference examples C (see Table 3-1, 3-2), the initial cycle was carried out under charge-discharge conditions similar to those in Example 1. Fig. 18 shows dQ/dV curves with respect to voltage (V) in a discharge process in the initial cycle.

As interpretation of dQ/dV from Sample 14 in Fig. 18, it was confirmed that crystallization of a Li-Si alloy was suppressed by adding elements (Zn, Al) in addition to Si, because the number of troughs was reduced in a region of low potential (0.4 V or lower) and the curve became smooth. It was also confirmed that decomposition of an electrolytic solution (around 0.4 V or so) was suppressed. Here, Q represents battery capacity (discharge capacity).

To be specific, in Sample 42 (a metallic thin film of pure Si) in the reference examples C, steep troughs at around 0.4 V indicate changes due to decomposition of an electrolytic solution. Then, the moderate troughs at around 0.35 V, 0.2 V, and 0.05 V indicate changes from an amorphous state to a crystallized state, respectively.

On the other hand, in Sample 14 (a thin film of a Si-Zn-Al ternary alloy) of the reference examples C, in which elements (Zn, Al) were added in addition to Si, since there was no steep trough, it was confirmed that decomposition of an electrolytic solution (around 0.4 V or so) was suppressed. Further, in the dQ/dV curve of Sample 14 in the reference examples C, it was confirmed that crystallization of a Li-Si alloy was suppressed since the curve was smooth, and there were no moderate trough that shows a change from an amorphous state to a crystalized state.

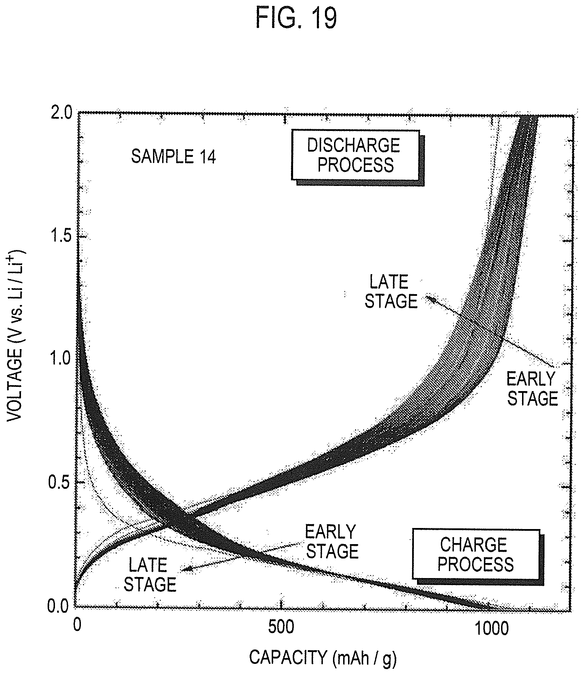

With the cell for evaluation (CR2032 coin cell) which used an electrode for evaluation of Sample 14 of the reference examples C, the initial cycle-the 50th cycle were carried out under charge-discharge conditions similar to those stated above. Fig. 19 shows charge-discharge curves from initial cycle-the 50th cycle. A charge process in the drawing shows a state of a charge curve per cycle by lithiation in the electrode for evaluation of Sample 14. A discharge process shows a state of a discharge curve per cycle by delithiation.

In Fig. 19, the curves of the cycles are densely located, which shows that cycle deterioration is small. The charge-discharge curves have only small kinks (twists, torsions), which show that an amorphous state is maintained. In addition, a difference in capacity between charge and discharge is small, which shows that efficiency of charge and discharge is good.

From the foregoing results of the experiments, it is possible to assume (estimate) the following because ternary alloys of Samples 1-35 of the reference examples C, particularly the ternary alloys of samples within the composition ranges surrounded by the thick solid lines in Fig. 15-Fig. 17, have a mechanism (mechanism of action) that shows good balanced characteristics where discharge capacity is high in the 1st cycle while maintaining high cycle characteristics (especially, a high discharge capacity retention rate in the 50th cycle).

1. As shown in Fig. 18, the dQ/dV curve of the ternary alloy (Sample 14) is smooth as the number of peaks in a low potential region (∼ 0.6 V) is smaller compared to that of pure Si (Sample 42) that is not an alloy. It is considered to mean that decomposition of an electrolytic solution is suppressed, and phase transition of a Li-Si alloy to a crystalline phase is suppressed (see Fig. 18).
2. Regarding decomposition of an electrolytic solution, it is shown that discharge capacity is reduced in all Samples 1-48 due to the decomposition as the number of cycles increases (see Table 3-1, Table 3-2). However, when discharge capacity retention rates are compared, it is understood that a remarkably higher retention rate is realized with a ternary alloy compared to pure Si of Sample 42, that is not an alloy. It is also shown that a higher discharge capacity retention rate is realized compared to those of the already-existing high capacity Sn-based negative electrode active material, the multicomponent alloy negative electrode active material described in Patent Literature 1, and also a binary alloy negative electrode active material for reference. As a result, it is understood that cycle characteristics tend to improve by realizing a high discharge capacity retention rate (see discharge capacity retention rates in the 50th cycle in Table 3-1, Table 3-2).
3. Regarding phase transition of a Li-Si alloy into a crystalline phase, a volume change of an active material becomes large when this phase transition happens. Accordingly, a chain of breakage of the active material itself and breakage of an electrode begins. It is possible to determine from the dQ/dV curve in Fig. 18 that, in Sample 14 of a ternary alloy within the composition ranges surrounded by the thick solid lines in Fig. 15-Fig. 17, phase transition can be suppressed because there is only a small number of peaks caused by phase transition, and the curve is smooth.

### (Reference examples D): Performance evaluation of SiₓZn_{y}C_{z}Aₐ - not falling under the scope of the present invention

### [1] Preparation of negative electrodes

For the target stated in (1) in reference examples A, "Zn: diameter of 50.8 mm, thickness of 5 mm" was changed to "Zn: diameter of 50.8 mm, thickness of 3 mm", and "V: diameter of 50.8 mm, thickness of 5 mm" was changed to "C: diameter of 50.8 mm, thickness of 3 mm (with a 2 mm-thick backing plate made of oxygen free copper)". Further, for DC power supply in (2), "Zn (0-50 W), V (0-150 W)" was changed to "Zn (20-90 W), C (30-90 W)". Apart from these changes, in the similar way to reference examples A, 29 types of negative electrode samples were fabricated in total (Samples 1-29 of reference examples D).

In short, the Si target, Zn target, and C target stated above were used, sputtering time was fixed to 10 minutes, and then power of DC power supply was changed within the above-mentioned range. In this way, alloy thin films in an amorphous state were deposited on Ni substrates, and negative electrode samples having alloy thin films with various compositions were obtained.

As some examples of sample preparation conditions regarding the DC power supply in (2) above, for Sample No. 5 (reference example) of reference examples D, DC power supply 1 (Si target) is set to 185 W, DC power supply 2 (C target) is set to 60 W, and DC power supply 3 (Zn target) is set to 30 W. Further, in Sample No. 22 (comparative reference example) of reference examples D, DC power supply 1 (Si target) is set to 185 W, DC power supply 2 (C target) is set to 45 W, and DC power supply 3 (Zn target) is set to 0 W. Furthermore, in Sample No. 26 (comparative reference example) of reference examples D, DC power supply 1 (Si target) is set to 185 W, DC power supply 2 (C target) is set to 0 W, and DC power supply 3 (Zn target) is set to 28 W.

The component compositions of these alloy thin films are shown in Table 4 and Fig. 20. Analysis of the alloy thin films obtained was carried out by the analysis process and the apparatus similar to those for reference examples A.

### [2] Preparation of batteries

CR2032 coin cells were fabricated in a similar way to those in reference examples A.

### [3] Battery charge-discharge test

Charge-discharge test of a battery was conducted in a similar way to that in reference examples A. Charge capacity and discharge capacity in the 1 st cycle, and discharge capacity in the 50th cycle were measured, and each item in Table 4 was calculated. The results are also shown in Table 4. In Table 4, a discharge capacity retention rate (%) after 50 cycles shows a percentage of discharge capacity in the 50th cycle for discharge capacity in the 1st cycle ((discharge capacity in the 50th cycle) / (discharge capacity in the 1st cycle)) × 100. Further, "charge-discharge efficiency" shows a percentage of charge capacity to discharge capacity (discharge capacity / charge capacity × 100).

**[Table 4]**

| No. | Composition (mass%) | | | Discharge capacity in the early stage (the 1 st cycle) (mAh/g) | Discharge capacity retention rate after 50th cycles (%) | Charge and discharge efficiency in the early stage (the 1st cycle) (%) | Classification |
|---|---|---|---|---|---|---|---|
| | Si | Zn | C | | | | |
| 1 | 53.40 | 44.00 | 2.60 | 1819 | 77 | 100 | Reference example D1 |
| 2 | 42.45 | 55.48 | 2.07 | 1668 | 74 | 98 | Reference example D2 |
| 3 | 35.22 | 63.06 | 1.72 | 1378 | 77 | 97 | Reference example D3 |
| 4 | 30.10 | 68.43 | 1.47 | 1221 | 72 | 97 | Reference example D4 |
| 5 | 51.95 | 17.68 | 30.37 | 1693 | 75 | 99 | Reference example D5 |
| 6 | 34.59 | 45.20 | 20.21 | 1326 | 78 | 98 | Reference example D6 |
| 7 | 29.63 | 53.05 | 17.32 | 1215 | 71 | 98 | Reference example D7 |
| 8 | 25.92 | 58.93 | 15.15 | 1129 | 74 | 98 | Reference example D8 |
| 9 | 39.85 | 13.57 | 46.59 | 1347 | 69 | 99 | Reference example D9 |
| 10 | 28.77 | 37.60 | 33.63 | 1103 | 79 | 98 | Reference example D10 |
| 11 | 25.26 | 45.21 | 29.53 | 1059 | 72 | 98 | Reference example D11 |
| 12 | 97.73 | 1.79 | 0.48 | 3099 | 48 | 89 | Comparative reference example D1 |
| 13 | 84.44 | 15.15 | 0.41 | 2752 | 52 | 90 | Comparative reference example D2 |
| 14 | 74.33 | 25.31 | 0.36 | 2463 | 53 | 89 | Comparative reference example D3 |
| 15 | 82.56 | 1.51 | 15.93 | 2601 | 59 | 90 | Comparative reference example D4 |
| 16 | 72.87 | 13.07 | 14.06 | 2483 | 68 | 90 | Comparative reference example D5 |
| 17 | 65.22 | 22.20 | 12.58 | 2136 | 55 | 90 | Comparative reference example D6 |
| 18 | 100.00 | 0.00 | 0.00 | 3232 | 47 | 91 | Comparative reference example D7 |
| 19 | 95.36 | 0.00 | 4.64 | 3132 | 58 | 92 | Comparative reference example D8 |
| 20 | 83.69 | 0.00 | 16.31 | 2778 | 64 | 91 | Comparative reference example D9 |
| 21 | 71.96 | 0.00 | 28.04 | 2388 | 51 | 91 | Comparative reference example D10 |
| 22 | 69.52 | 0.00 | 30.48 | 2370 | 68 | 91 | Comparative reference example D11 |
| 23 | 67.24 | 0.00 | 32.76 | 2295 | 54 | 91 | Comparative reference example D12 |
| 24 | 65.11 | 0.00 | 34.89 | 2240 | 32 | 87 | Comparative reference example D13 |
| 25 | 63.11 | 0.00 | 36.89 | 2120 | 59 | 91 | Comparative reference example D14 |
| 26 | 85.15 | 14.85 | 0.00 | 2618 | 76 | 88 | Comparative reference example D15 |
| 27 | 80.83 | 19.17 | 0.00 | 2268 | 70 | 87 | Comparative reference example D16 |
| 28 | 77.15 | 22.85 | 0.00 | 2132 | 74 | 87 | Comparative reference example D17 |
| 29 | 73.97 | 26.03 | 0.00 | 2640 | 80 | 89 | Comparative reference example D18 |

In Table 4, Examples 1 to 29 do not fall under the scope of the present invention.

From Table 4, it is shown that the batteries of Sample No. 1-11 according to reference examples D have good balance between the charge-discharge efficiency in the early stage and the discharge capacity retention rate. It was confirmed that the balance is particularly good within ranges where the foregoing x is more than 25 and less than 54, the foregoing y is more than 17 and less than 69, and the foregoing z is more than 1 and less than 34 (see Fig. 21). On the contrary, in the batteries of Sample No. 12-29 according to comparative reference examples D, it is shown that charge capacity in the early stage is larger than that of the batteries of reference examples D, but the charge-discharge efficiency in the early stage and/or the discharge capacity retention rates were remarkably reduced.

Next, as examples, Si₄₁Zn₂₀Sn₃₉ out of the above-mentioned Si alloys was used to carry out performance evaluation on negative electrodes for an electric device, which contain a negative electrode active material made by being mixed with graphite.

The alloys used in the present invention other than Si₄₁Zn₂₀Sn₂₃ (any of SiₓZn_{y}V_{z}Aₐ, SiₓZn_{y}Sn_{z}Aₐ, SiₓZn_{y}Al_{z}Aₐ, SiₓZn_{y}C_{z}Aₐ except Si₄₁Zn₂₀Sn₃₉) show the same or similar results to the examples described below employing Si₄₁Zn₂₀Sn₃₉. The reason therefor is that the other alloys used in the present invention have similar properties to those of Si₄₁Zn₂₀Sn₃₉ as shown by the reference examples. In the case of using alloys having similar characteristics, the same results can be obtained even if the alloy type is different.

### (Example 1)

### [Preparation of Si alloy]

The Si alloy is produced by mechanical alloying (or arc plasma melting). To be specific, in a planetary ball mill P-6 (by FRITCSH in German), powder of the raw materials of each alloy is put into a zirconia pulverizing pot together with zirconia pulverization balls to be alloyed at 600 rpm for 48 h.

### [Preparation of Negative electrode]

2.76 parts by mass of the Si alloy (Si₄₁Zn₂₀Sn₃₉, particle diameter of 0.3 µm) manufactured as above as a negative electrode active material, 89.24 parts by mass of graphite (an average particle diameter of 22 µm), 4 parts by mass of acetylene black serving as an electrically-conductive auxiliary agent, and 4 parts by mass of polyimide serving as a binder were mixed, dispersed in N-methylpyrrolidone, and negative electrode slurry was obtained. Next, the obtained negative electrode slurry was uniformly applied on both surfaces of the negative electrode current collector that is made of a 10 µm-thick copper foil, so that each of negative electrode active material layers has a thickness of 30 µm, dried in vacuum for 24 hours, and a negative electrode was obtained. A content rate of the Si alloy in the negative electrode active material was 3%.

### [Preparation of Positive electrode]

Li_{1.85}Ni_{0.18}Co_{0.10}Mn_{0.87}O₃ as the positive electrode active material is prepared by a method described in Example 1 (Paragraph 0046) of Japanese Unexamined Patent Application Publication No. 2012-185913. 90 parts by mass of the prepared positive electrode active material, 5 parts by mass of acetylene black as the electrically-conductive auxiliary agent, and 5 parts by mass of polyvinylidene fluoride as the binder are mixed and the dispersed in N-methylpyrrolidone to form positive electrode slurry. The obtained positive electrode slurry is then evenly applied to both sides of a positive electrode current collector made of 20 µm-thick aluminum foil so that the positive electrode active material layers have thicknesses of 30 µm, followed by drying, thus obtaining a positive electrode.

### [Preparation of Battery]

The positive electrode and negative electrode prepared as described above are placed facing each other with a separator (20 µm-thick microporous film made of polypropylene) provided therebetween. The layered product of the negative electrode, separator, and positive electrode is placed in the bottom portion of a coin cell (CR2032, made of stainless steel (SUS316)). Moreover, a gasket is attached to the same to keep the positive electrode and negative electrode isolated from each other; the electrolytic solution described below is injected through a syringe; a spring and a spacer are stacked thereon; the upper portion of the coin cell is laid thereon and caulked to be sealed, thus obtaining a lithium ion secondary battery.

The electrolytic solution is a solution obtained by dissolving lithium hexafluorophosphate (LiPF₆) as the supporting salt in an organic solvent to a concentration of 1 mol/L. The organic solvent is a mixture of ethylene carbonate (EC) and diethylene carbonate (DEC) in a volume ratio of 1/2 (EC /DEC).

### (Example 2)

A negative electrode and a battery were prepared in the similar way to that of Example 1 except that the Si alloy was changed to 4.6 parts by mass and graphite was changed to 87.4 parts by mass. The content rate of the Si alloy in the negative electrode active material was 5%.

### (Example 3)

A negative electrode and a battery were prepared in the similar way to that of Example 1 except that the Si alloy was changed to 6.44 parts by mass and graphite was changed to 85.56 parts by mass. The content rate of the Si alloy in the negative electrode active material was 7%.

### (Example 4)

A negative electrode and a battery were prepared in the similar way to that of Example 1 except that the Si alloy was changed to 9.2 parts by mass and graphite was changed to 82.8 parts by mass. The content rate of the Si alloy in the negative electrode active material was 10%.

### (Example 5)

A negative electrode and a battery were prepared in the similar way to that of Example 1 except that the Si alloy was changed to 11.04 parts by mass and graphite was changed to 80.96 parts by mass. The content rate of the Si alloy in the negative electrode active material was 12%.

### (Example 6)

A negative electrode and a battery were prepared in the similar way to that of Example 1 except that the Si alloy was changed to 13.8 parts by mass and graphite was changed to 78.2 parts by mass. The content rate of the Si alloy in the negative electrode active material was 15%.

### (Example 7)

A negative electrode and a battery were prepared in the similar way to that of Example 1 except that the Si alloy was changed to 18.4 parts by mass and graphite was changed to 73.6 parts by mass. The content rate of the Si alloy in the negative electrode active material was 20%.

### (Example 8)

A negative electrode and a battery were prepared in the similar way to that of Example 1 except that the Si alloy was changed to 23.0 parts by mass and graphite was changed to 69.0 parts by mass. The content rate of the Si alloy in the negative electrode active material was 25%.

### (Example 9)

A negative electrode and a battery were prepared in the similar way to that of Example 1 except that the Si alloy was changed to 27.6 parts by mass and graphite was changed to 64.4 parts by mass. The content rate of the Si alloy in the negative electrode active material was 30%.

### (Example 10)

A negative electrode and a battery were prepared in the similar way to that of Example 1 except that the Si alloy was changed to 36.8 parts by mass and graphite was changed to 55.2 parts by mass. The content rate of the Si alloy in the negative electrode active material was 40%.

### (Example 11)

A negative electrode and a battery were prepared in the similar way to that of Example 1 except that the Si alloy was changed to 46.0 parts by mass and graphite was changed to 46.0 parts by mass. The content rate of Si alloy in the negative electrode active material was 50%.

### (Example 12)

A negative electrode and a battery were prepared in the similar way to that of Example 1 except that the Si alloy was changed to 55.2 parts by mass and graphite was changed to 36.8 parts by mass. The content rate of the Si alloy in the negative electrode active material was 60%.

### (Example 13)

A negative electrode and a battery were prepared in the similar way to that of Example 1 except that the Si alloy was changed to 64.4 parts by mass and graphite was changed to 27.6 parts by mass. The content rate of the Si alloy in the negative electrode active material was 70%.

### <Performance evaluation>

### [Evaluation of Cycle Characteristic]

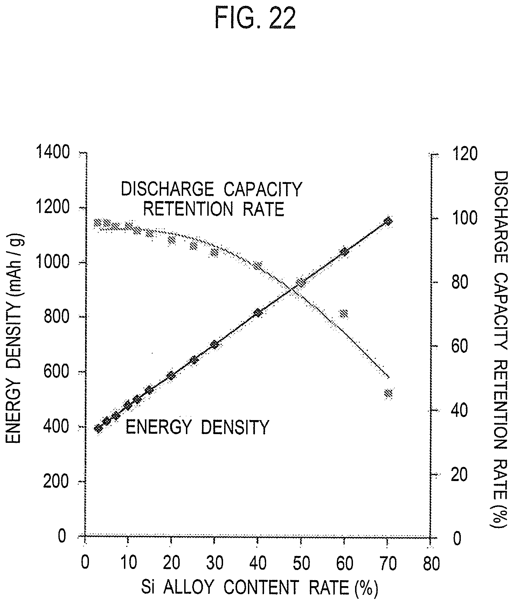

The lithium ion secondary batteries prepared above are subjected to cycle characteristic evaluation in the following manner. Each battery is charged to 2.0 V in the atmosphere of 30°C in constant-current mode (CC, current: 0.1 C) and is rested for 10 minutes. Subsequently, the battery is discharged to 0.01 V in constant-current mode (CC, current: 0.1 C) and is then rested for 10 minutes. Herein, the above charge and discharge are considered as one cycle. Each lithium ion secondary battery is subjected to the charge-discharge test for 100 cycles, and the ratio of discharge capacity at the 100th cycle to the discharge capacity at the first cycle (discharge capacity retention rate (%)) is calculated. The obtained results are shown in Table 4 and Fig. 22 below.

### [Evaluation of Energy Density]

The lithium ion secondary batteries prepared above are subjected to cycle characteristic evaluation in the following manner. As the initial charge and discharge process, each battery is charged with a current of 0.2 C to the theoretical capacity of the positive electrode in constant-current mode and then is charged at a constant voltage of 4.2 V for 10 hours in total. Subsequently, the battery is discharged to 2.7 V in constant-current mode with a discharge current of 0.2 C. The battery energy is calculated from the charge-discharge curve in this process and is divided by the battery weight, thus calculating the energy density of the battery. The obtained results are shown in Table 5 and Fig. 22 below.

**[Table 5]**

| | Content rate of Si alloy (%) | Discharge capacity retention rate (%) | Energy density (mAh/g) |
|---|---|---|---|
| Example 1 | 3 | 98 | 397 |
| Example 2 | 5 | 98 | 420 |
| Example 3 | 7 | 97 | 443 |
| Example 4 | 10 | 97 | 477 |
| Example 5 | 12 | 96 | 499 |
| Example 6 | 15 | 95 | 534 |
| Example 7 | 20 | 93 | 590 |
| Example 8 | 25 | 91 | 647 |
| Example 9 | 30 | 89 | 704 |
| Example 10 | 40 | 85 | 818 |
| Example 11 | 50 | 80 | 932 |
| Example 12 | 60 | 70 | 1045 |
| Example 13 | 70 | 45 | 1159 |

From the results in Table 5 and Fig. 22, it is understood that the batteries in Examples 1-13 that used the negative electrode active material made by mixing the Si alloy and graphite had good balanced characteristics where initial capacity is high while maintaining high cycle characteristics.

### REFERENCE SIGNS LIST

10,50 LITHIUM ION SECONDARY BATTERY (LAMINATED BATTERY)
11 POSITIVE ELECTRODE CURRENT COLLECTOR
12 NEGATIVE ELECTRODE CURRENT COLLECTOR
13 POSITIVE ELECTRODE ACTIVE MATERIAL LAYER
15 NEGATIVE ELECTRODE ACTIVE MATERIAL LAYER
17 ELECTROLYTE LAYER
19 SINGLE CELL LAYER
21, 57 POWER GENERATION ELEMENT
25, 58 POSITIVE ELECTRODE CURRENT COLLECTING PLATE
27, 59 NEGATIVE ELECTRODE CURRENT COLLECTING PLATE
29, 52 BATTERY EXTERIOR MEMBER (LAMINATED FILM)

## Claims

1. A negative electrode for an electric device, comprising: a current collector; and an electrode layer containing a negative electrode active material, an electrically-conductive auxiliary agent and a binder and formed on a surface of the current collector,
wherein the negative electrode active material is a mixture of a carbon material and an alloy represented by the following formula (1):
SiₓZn_{y}M_{z}Aₐ ... (1)
in formula (1), M is Sn,
A is inevitable impurity,
x, y, z and a represent mass percent values, and
the x, y, z and a satisfy 23 < x < 64, 2 < y < 65, 4 ≤ z < 34, and 0 ≤ a < 0.5, and x +y+z+a=100;
or the x, y, z and a satisfy 23 < x < 44, 0 < y < 65, 34 < z < 58, and 0 ≤ a < 0.5, and x + y + z + a = 100, and
wherein the alloy has an average particle diameter smaller than that of the carbon material.

2. The negative electrode for an electric device according to claim 1, wherein a content rate of the alloy in the negative electrode active material is 3 to 70 mass%.

3. The negative electrode for an electric device according to claim 2, wherein the content rate of the alloy in the negative electrode active material is 30 to 50 mass%.

4. The negative electrode for an electric device according to claim 2, wherein the content rate of the alloy in the negative electrode active material is 50 to 70 mass%.

5. The negative electrode for an electric device according to any one of claims 1 to 4, wherein the x, y, z and a satisfy 23 < x < 64, 27 < y < 61, 4 ≤ z < 34, and 0 ≤ a < 0.5, and x + y + z + a = 100.

6. The negative electrode for an electric device according to any one of claims 1 to 4, wherein the x, y, z and a satisfy 23 < x < 34, 0 < y < 65, 34 ≤ z ≤ 58, and 0 ≤ a < 0.5, and x + y + z + a = 100.

7. The negative electrode for an electric device according to claim 5, wherein the y and z are 38 < y < 61, and 4 ≤ z < 24.

8. The negative electrode for an electric device according to claim 5 wherein the x is 24 ≤ x < 38.

9. The negative electrode for an electric device according to any one of claims 1 to 4, wherein the x, y, z and a satisfy 23 < x < 38, 27 < y < 65, 34 ≤ z < 40, and 0 ≤ a < 0.5, and x +y+z+a=100.

10. The negative electrode for an electric device according to any one of claims 2 to 4, wherein the x, y, z and a satisfy 23 < x < 29, 0 < y < 65, 40 ≤ z ≤ 58, and 0 ≤ a < 0.5, and x + y + z + a = 100.

11. An electric device comprising a negative electrode for an electric device according to any one of claims 1 to 10.

## Patentansprüche

1. Negativelektrode für eine elektrische Vorrichtung, umfassend: einen Stromkollektor; und eine Elektrodenschicht, die ein Negativelektrodenaktivmaterial, einen elektrisch leitenden Hilfsstoff und ein Bindemittel enthält und auf einer Oberfläche des Stromkollektors ausgebildet ist,
wobei das Negativelektrodenaktivmaterial eine Mischung aus einem Kohlenstoffmaterial und einer Legierung ist, die durch die folgende Formel (1) dargestellt ist:
SixZnyMzAa ... (1)
wobei M in der Formel (1) Sn ist,
A eine unvermeidbare Verunreinigung ist,
x, y, z und a Massenprozentwerte repräsentieren und
x, y, z und a 23 < x <64, 2 <y <65, 4 ≤ z < 34 und 0 ≤ a <0,5 und x + y + z + a = 100 erfüllen;
wobei die Legierung einen durchschnittlichen Teilchendurchmesser aufweist, der kleiner als der des Kohlenstoffmaterials ist.

2. Negativelektrode für eine elektrische Vorrichtung nach Anspruch 1,
wobei ein Gehaltsanteil der Legierung im Negativelektrodenaktivmaterial 3 bis 70 Masse-% beträgt.

3. Negativelektrode für eine elektrische Vorrichtung nach Anspruch 2,
wobei der Gehaltsanteil der Legierung im Negativelektrodenaktivmaterial 30 bis 50 Masse-% beträgt.

4. Negativelektrode für eine elektrische Vorrichtung nach Anspruch 2,
wobei der Gehaltsanteil der Legierung im Negativelektrodenaktivmaterial 50 bis 70 Masse-% beträgt.

5. Negativelektrode für eine elektrische Vorrichtung nach einem der Ansprüche 1 bis 4, wobei x, y, z und a 23 <x <64, 27 <y <61, 4 ≤ z <34 und 0 ≤ a <0,5 und x + y + z + a = 100 erfüllen.

6. Negativelektrode für eine elektrische Vorrichtung nach einem der Ansprüche 1 bis 4, wobei x, y, z und a 23 <x <34, 0 <y <65, 34 ≤ z ≤ 58 und 0 ≤ a <0,5 und x + y + z + a = 100 erfüllen.

7. Negativelektrode für eine elektrische Vorrichtung nach Anspruch 5,
wobei y und z 38 <y <61 und 4 ≤ z <24 sind.

8. Negativelektrode für eine elektrische Vorrichtung nach Anspruch 5,
wobei x 24 ≤ x <38 ist.

9. Negativelektrode für eine elektrische Vorrichtung nach einem der Ansprüche 1 bis 4, wobei x, y, z und a 23 <x <38, 27 <y <65, 34 ≤ z <40 und 0 ≤ a <0,5 und x + y + z + a = 100 erfüllen.

10. Negativelektrode für eine elektrische Vorrichtung nach einem der Ansprüche 2 bis 4, wobei x, y, z und a 23 <x <29, 0 <y <65, 40 ≤ z ≤ 58 und 0 ≤ a <0,5 und x + y + z + a = 100 erfüllen.

11. Elektrische Vorrichtung, die eine Negativelektrode für eine elektrische Vorrichtung nach einem der Ansprüche 1 bis 10 umfasst.

## Revendications

1. Électrode négative pour un dispositif électrique, comprenant : un collecteur de courant ; et une couche d'électrode contenant un matériau actif d'électrode négative, un agent auxiliaire électroconducteur et un liant et formée sur une surface du collecteur de courant,
dans laquelle le matériau actif d'électrode négative est un mélange d'un matériau carboné et d'un alliage représenté par la formule (1) suivante :
SiₓZn_{y}M_{z}Aₐ .... (1)
dans la formule (1), M représente Sn,
A représente une impureté inévitable,
x, y, z et a représentent des valeurs de pourcentage massique, et
x, y, z et a satisfont 23 < x < 64, 2 < y < 65, 4 ≤ z < 34, et 0 ≤ a < 0,5, et x + y + z + a = 100 ;
ou x, y, z et a satisfont 23 < x < 44, 0 < y < 65, 34 < z < 58 et 0 ≤ a < 0,5, et x + y + z + a = 100, et
dans laquelle l'alliage a un diamètre moyen de particules inférieur à celui du matériau carboné.

2. Électrode négative pour un dispositif électrique selon la revendication 1, dans laquelle un taux de teneur en alliage dans le matériau actif d'électrode négative est compris entre 3 et 70% en masse.

3. Électrode négative pour un dispositif électrique selon la revendication 2, dans laquelle le taux de teneur en alliage dans le matériau actif d'électrode négative est compris entre 30 et 50% en masse.

4. Électrode négative pour un dispositif électrique selon la revendication 2, dans laquelle le taux de teneur en alliage dans le matériau actif d'électrode négative est compris entre 50 et 70% en masse.

5. Électrode négative pour un dispositif électrique selon l'une quelconque des revendications 1 à 4, dans laquelle x, y, z et a satisfont 23 < x < 64, 27 < y < 61, 4 ≤ z < 34, et 0 ≤ a < 0,5 et x + y + z + a = 100.

6. Électrode négative pour un dispositif électrique selon l'une quelconque des revendications 1 à 4, dans laquelle x, y, z et a satisfont 23 < x < 34, 0 < y < 65, 34 ≤ z ≤ 58, et 0 ≤ a < 0,5 et x + y + z + a = 100.

7. Électrode négative pour un dispositif électrique selon la revendication 5, dans laquelle y et z sont tels que 38 < y < 61 et 4 ≤ z < 24.

8. Électrode négative pour un dispositif électrique selon la revendication 5, dans laquelle x est tel que 24 ≤ x < 38.

9. Électrode négative pour un dispositif électrique selon l'une quelconque des revendications 1 à 4, dans laquelle x, y, z et a satisfont 23 < x < 38, 27 < y < 65, 34 ≤ z < 40 et 0 ≤ a < 0,5, et x + y + z + a = 100.

10. Électrode négative pour un dispositif électrique selon l'une quelconque des revendications 2 à 4, dans laquelle x, y, z et a satisfont 23 < x < 29, 0 < y < 65, 40 ≤ z ≤ 58, et 0 ≤ a < 0,5, et x + y + z + a = 100.

11. Dispositif électrique comprenant une électrode négative pour un dispositif électrique selon l'une quelconque des revendications 1 à 10.
